# EUROPÄISCHE PATENTANMELDUNG

(11) **EP 3 130 950 A1**
(43) Veröffentlichungstag der Anmeldung: **15.02.2017**
(21) Anmeldenummer: 15180448.1
(22) Anmeldetag: 10.08.2015
(51) Int. Cl.: G02B 6/42

(54) **STRAHLUMLENKELEMENT SOWIE OPTISCHES BAUELEMENT MIT STRAHLUMLENKELEMENT**

(71) Anmelder: MULTIPHOTON OPTICS GMBH, 97076 Würzburg (DE)
(72) Erfinder: Houbertz, Ruth, 97074 Würzburg (DE); Esslinger, Moritz, 97080 Würzburg (DE)
(74) Vertreter: Strehl Schübel-Hopf & Partner

(57) **Zusammenfassung**

Die vorliegende Erfindung betrifft ein Strahlumlenkelement mit Abmessungen von unter 1 mm in allen drei Raumrichtungen, das zur Anordnung auf einem Strahlungsausgangs- und/oder -eingangselement vorgesehen ist und eine Eintrittsfläche für eintretende Strahlung sowie eine Austrittsfläche für diese Strahlung besitzt, wobei mindestens eine dieser Flächen eben ausgebildet ist, derart, dass sie auf einer Austritts- oder Eintrittsfläche eines Strahlungsausgangs- oder -eingangselements zu liegen kommen kann, wobei die Eintrittsfläche und die Austrittsfläche des Strahlumlenkelements winklig zueinander angeordnet sind, dadurch gekennzeichnet, dass das Strahlumlenkelement mindestens zwei den Weg der durch das Element hindurchtretenden Strahlung beeinflussende Flächen aufweist, deren eine eine Umlenkung mindestens eines Teils der einfallenden Strahlung bewirkt und deren andere bewirkt, dass sich die Strahldivergenz und/oder die Strahlform ändert. Des Weiteren betrifft die Erfindung ein optisches Bauelement, umfassend ein Substrat mit einer Substratoberfläche (1) und ein auf der Substratoberfläche befindliches Strahlungsausgangselement (2) und/oder Strahlungseingangselement (2), auf dem ein derartiges Strahlumlenkelement angeordnet ist

## Beschreibung

Die vorliegende Erfindung betrifft ein (mikro)optisches Bauelement, das als solches oder integriert in ein Bauelement mit weiteren optischen und/oder elektronischen Komponenten vorliegen kann. Das erfindungsgemäße Bauelement umfasst ein Strahlumlenkelement, das so gestaltet ist, dass es elektromagnetische Strahlung, die im Wesentlichen vertikal aus einem Lichtemitter oder über ein Gitter zur Strahlungsauskopplung oder dergleichen (ganz allgemein: Strahlungsausgangselement) austritt, oder die im Wesentlichen vertikal in einen Detektor oder ein Gitter zur Strahlungseinkopplung (ganz allgemein: Strahlungseingangselement) eintritt, unter besonders günstigen geometrischen Bedingungen aus der Lichtquelle um- und in eine lichtempfangende Struktur (oder in den Raum) lenken bzw. aus einer lichtaussendenden Struktur (oder dem Raum) um- und in den optischen Eingang lenken kann.

Optische oder optoelektronische Bauelemente enthalten in der Regel ein oder mehrere Strahlungseingangs- oder -ausgangselemente wie Lichtemitter (z.B. VCSEL, kantenemittierender Laser, LED), Detektoren, Gitter zur Lichteinkopplung, Gitter zur Lichtauskopplung und Strahlumlenker in einem photonischen Chip oder Board. Diese befinden sich meist auf einem Substrat und senden bzw. empfangen elektromagnetische Strahlung im Wesentlichen senkrecht zur Substratoberfläche. Wird, was der häufigste Fall ist, ein Lichtleiter, z.B. aus Glas, direkt auf das Strahlungseingangs- oder -ausgangselement aufgesetzt, kann dieser nicht ohne weiteres parallel zur Substratoberfläche geführt werden, weil dies eine Biegung seines Endbereichs um 90° voraussetzen würde, was materialtechnisch nicht miniaturisiert realisierbar ist. Im Stand der Technik wird dies z.B. durch das Aufsetzen von Glasfasern realisiert. Typische Biegeradien liegen im Bereich von 1-2 cm. Somit hat das Bauteil bzw. die Komponente nach dem Stand der Technik eine Größe von mehr als 1 cm. Dies führt dazu, dass das optische Bauelement nicht so flach gestaltet werden kann, wie es gewünscht wäre.

Um dennoch eine Umlenkung zumindest eines Teils der Strahlung aus der im Wesentlichen vertikalen Richtung aus dem/in das Strahlungsausgangs-/-eingangselement zu bewirken, wird im Stand der Technik vorgeschlagen, Spiegelflächen oder Hohlspiegel einzusetzen, die die Strahlung um ca. 90° umlenken und teilweise dabei sammeln können. So verwendet JP 2005/338696 A einen konkaven Spiegel, der in eine geneigte Fläche einer Ausnehmung eingearbeitet ist, um eine entsprechende Strahlumlenkung zu bewirken. Gemäß US 2011/0235964 A1 erfolgt eine Umlenkung aus/in einen durch Einspannen befestigten Wellenleiter über eine abgeschrägte Fläche am Ende dieses Wellenleiters. Eine optoelektronische Leiterplatte, die in JP 2008/250007 A beschrieben wird, enthält ebenfalls einen Wellenleiter, dessen Kern an seinem Ende mit einem Spiegel versehen ist, der eine Neigung von 45° besitzt, so dass die Strahlung aus dem Wellenleiter um 90° in ein lichtaufnehmendes Element umgelenkt werden kann. Das in JP 1020140077533 A beschriebene optische Substrat enthält ebenfalls einen Wellenleiter auf einer Oberfläche des Substrats; dort ist eine Öffnung mit einer spiegelnden Vertiefung vorgesehen, die metallisch beschichtet ist.

US 2011/0262081 A1 beschreibt eine aktive optische Verbindung aus mindestens einem optoelektronischen Element, das über eine Drahtverbindung mit einem Substrat verbunden ist. Der Drahtbond ist in ein polymerisiertes Material eingebettet, das eine lichtablenkende Oberfläche bildet. Über diese Oberfläche wird Licht aus dem optoelektronischen Element in einen quer zu dessen Strahlrichtung angeordneten Lichtleiter umgelenkt. Dieses Lichtumlenkmittel, das einstückig mit den Einschlüssen für den VCSEL, kontaktierende Drahtanschlüsse, Wirebonds und Faserzuführkanäle und mit endseitigen Zuführtrichteröffnungen gebildet ist, wird aus UV-härtbarem Epoxidharz hergestellt, und zwar mittels eines PDMS-Zwischenstempels. Seine der Atmosphäre ausgesetzte Fläche kann eben oder aber wie ein Hohlspiegel gekrümmt sein, derart, dass sich eine maximale Energieeinkopplung in die Lichtleitfaser ergibt.

In WO 2006/012819 wird ein Halbleiterlaser-Bauelement mit einem zur Strahlungserzeugung vorgesehenen Halbleiterlaserchip und einer optischen Vorrichtung beschrieben, die einen Träger, ein auf dem Träger angeordnetes Strahlungsumlenkelement und einen auf dem Träger angeordneten externen Spiegel eines externen optischen Resonators umfasst. Das Strahlungsumlenkungselement ist anodisch auf den Träger gebondet, geklebt oder gelötet und ist zur Umlenkung zumindest eines Teils einer vom Halbleiterlaserchip erzeugten und vom externen Spiegel reflektierten Strahlung ausgebildet. Es kann ein Glasprisma sein und lenkt die einfallende Strahlung bevorzugt um einen Winkel von 90° um, indem seine Reflektorfläche mit der Hauptfläche des Trägers einen Winkel von ungefähr 45° einschließt. In einer Alternative ist es hochreflektiv für eine erste Strahlung und hochtransmittiv für eine an anderer Stelle frequenzkonvertierte Strahlung, wofür die Reflektorfläche entsprechend beschichtet sein kann. In einer weiteren Alternative kann es als vorzugsweise dichroitischer Strahlteiler ausgeführt sein.

Ein Leiterplattenelement mit einem Substrat, einem in einem schichtförmigen photopolymerisierbaren optischen Material eingebetteten optoelektronischen Bauelement und mit einem damit optisch gekoppelten Licht-Wellenleiter ist in WO 2007/128022 A2 beschrieben. Auf dem Substrat ist ein vorgefertigter Umlenkspiegel angeordnet, der im optischen Material eingebettet ist. Der Umlenkspiegel kann beispielsweise aus Silizium oder aus Glas mit Metallbeschichtung vorgefertigt sein und besteht vorzugsweise aus einem prismatischen Körper mit einer abgeschrägten oder konkaven Spiegelfläche. Er wird insbesondere durch Kleben auf das Substrat aufgebracht. Der Lichtwellenleiter wird innerhalb des photopolymerisierbaren optischen Materials mit Hilfe von TPA (Zwei-Photonen-Absoprtion) strukturiert, derart, dass er entweder direkt am Umlenkspiegel oder kurz davor endet.

Einen etwas anderen Umlenkspiegel zeigt WO 2007/128021 A1. Er besteht aus einem transparenten Material, das abgeformt werden kann, beispielsweise einem anorganisch-organischen Hybridpolymer oder Silikon. Er hat die ungefähre Form einer Halbkugel oder ist asphärisch gestaltet und ist an seiner Außenseite oder Rückenfläche verspiegelt. Erzeugt wird er in einem mehrschrittigen Verfahren aus einem optischen Replikationsmaterial, also einem noch nicht endgültig vernetzten Hybridpolymer oder Silikon, das vorzugsweise als Sol-Gel-Material vorliegt. Auf das ungeformt aufgebrachte Sol-Gel-Material wird eine transparente Maske aufgesetzt, die entsprechende Ausnehmungen besitzt, und sodann wird durch die Maske hindurch das Material belichtet und damit verfestigt.

Die im Stand der Technik vorgeschlagenen konkaven Strukturen haben gegenüber den einfachen Strahlumlenk-Flächen den Vorteil, dass sie den auftreffenden Strahl nicht nur umlenken, sondern auch bündeln können. Nachteilig an einem Sammelspiegel oder fokussierenden Spiegel bleibt aber Folgendes: Der von der Strahlquelle emittierte Lichtkegel wird an einer einzigen Fläche umgelenkt und fokussiert, derart, dass die Lichtstrahlen als meist paralleles Bündel aus der Umlenkeinrichtung austreten. Die Höhe des Strahls bedingt dabei den Durchmesser des austretenden Bündels. Eine ideale dünne Linse oder ein idealer Spiegel (die konkave Struktur) ändert die Strahlpositionen nicht, nur die Richtungen. Wenn das fokussierende Element den Strahl parallel bündelt, ändert sich der Strahldurchmesser nach dem Auftreffen auf die Linse nicht mehr. Er muss daher an der Position der Linse oder des Spiegels schon den Soll-Durchmesser haben. Der Abstand zwischen der Strahlquelle und der Linse oder des Spiegels ist daher festgelegt. Je nach der gewünschten Geometrie kann es daher erforderlich sein, relativ große Umlenkspiegel zu wählen. Kleinere Umlenkspiegel wären jedoch vorteilhaft, weil sie die Herstellung kompakterer, kleinerer und vor allem niedrigerer optischer Bauelemente und "Packages" ermöglichen. Mit kleineren Umlenkspiegeln kann es jedoch sein, dass entweder die gewünschte Strahl-Sollhöhe oder der gewünschte Strahldurchmesser nicht erreicht wird.

Aufgabe der Erfindung ist es, diesen Nachteil zu beseitigen und optische Bauelemente zur Kopplung von elektromagnetischer Strahlung mit Umlenkelementen bereitzustellen, bei denen die Strahlhöhe und der Durchmesser des abgegebenen Strahls unabhängig voneinander festgelegt werden können. Weiterhin ist es die Aufgabe der Erfindung, eine weitere Miniaturisierung zu ermöglichen, die z.B. eine Erhöhung der Packungsdichte auf dem optischen Bauelement bzw. auf einem dieses Bauelement enthaltenden Chip ermöglicht.

Die Aufgabe der Erfindung wird gelöst durch die Bereitstellung eines optischen Bauelements, umfassend
ein Substrat mit einer Substratoberfläche (1)
ein auf der Substratoberfläche angeordnetes Strahlungsausgangselement oder Strahlungseingangselement (2) und
ein Strahlumlenkelement (3), das zumindest teilweise unmittelbar auf dem Strahlungsausgangs-/-eingangselement (2) angeordnet und so gestaltet ist, dass es elektromagnetische Strahlung, die im Wesentlichen vertikal zur Substratoberfläche (1) aus dem Strahlungsausgangselement (2) austritt, umlenkt und dabei einen Strahl bildet, der gegenüber dem Austrittswinkel, den der das Strahlungsausgangselement verlassende Strahl mit der Substratoberfläche bildet, einen kleineren oder sogar negativen Winkel besitzt oder parallel zur Substratoberfläche ausgerichtet ist, oder dass es elektromagnetische Strahlung, die mit einem bestimmten Winkel zur Substratoberfläche in das Strahlumlenkelement (3) eintritt, fokussiert und in das Strahlungseingangselement (2) lenkt,
dadurch gekennzeichnet, dass das Strahlumlenkelement (3) mindestens zwei den Weg der durch das Element hindurchtretenden Strahlung beeinflussende Flächen aufweist, deren eine eine Umlenkung mindestens eines Teils der einfallenden Strahlung bewirkt und deren andere bewirkt, dass sich die Strahldivergenz und/oder die Strahlform ändert.

Die Erfindung betrifft auch ein Strahlumlenkelement als solches, das zur Anordnung auf einem Strahlungsausgangs- und/oder-eingangselement z.B. eines photonischen Chips vorgesehen ist und deshalb Abmessungen von unter 1 mm, vorzugsweise von unter 600 µm in jeder der drei Raumrichtungen haben sollte. Das Strahlumlenkelement besitzt eine Eintrittsfläche für eintretende Strahlung sowie eine Austrittsfläche für diese Strahlung und ist so ausgebildet, dass zumindest entweder die Eintrittsfläche oder die Austrittsfläche eben ausgebildet ist, derart, dass sie auf einer Austritts- oder Eintrittsfläche eines Strahlungsausgangs- oder -eingangselements zu liegen kommen kann. Die Eintrittsfläche und die Austrittsfläche sind in einem Winkel zueinander angeordnet, der vorzugsweise zwischen 70 und 110°, stärker bevorzugt zwischen 80 und 100° und besonders bevorzugt bei etwa 90° liegt. Das Strahlumlenkelement ist dadurch gekennzeichnet, dass es mindestens zwei den Weg der durch das Element hindurchtretenden Strahlung beeinflussende Flächen aufweist, deren eine eine Umlenkung mindestens eines Teils der einfallenden Strahlung bewirkt und deren andere bewirkt, dass sich die Strahldivergenz und/oder Strahlform ändert.

Unter "die Strahlung beeinflussende Flächen" werden erfindungsgemäß folgende Elemente verstanden: eine optisch wirksame Grenzfläche des Elements (a) zur Umgebungsatmosphäre (z.B. Luft) oder (b) zu einem das Strahlumlenkelement umgebenden Material, wie z.B. dem eines Lichtleiters, wobei die optische Wirksamkeit auf dem Unterschied des Brechungsindex des Materials, aus dem das Element zumindest an dieser Grenzfläche besteht, zum Brechungsindex der Umgebung beruht, oder (c) eine optisch wirksame Grenzfläche innerhalb des Elements, die z.B. dadurch hervorgerufen werden kann, dass innerhalb des Elements zwei Materialien mit unterschiedlichen Brechungsindices aufeinandertreffen.

"Optisch wirksam" bedeutet dabei, dass die genannten Grenzflächen die Richtung von Lichtstrahlen in einem Strahlenbündel beeinflussen, d.h. eine Brechkraft besitzen, z.B. durch diffraktive Elemente, refraktive Elemente oder reflektive Elemente. Eine einzige Grenzfläche kann dabei mehrere dieser Funktionen ausüben und dabei z.B. als Strahlteiler wirken.

Unter "fokussieren" soll erfindungsgemäß in der Regel das Bewirken einer Strahlformänderung verstanden werden, wobei die Strahlen hinter der das Fokussieren bewirkenden Fläche (der Fläche mit Brechkraft) in Richtung eines Brennpunkts laufen (konvergierender Strahl). In manchen Fällen wird der Ausdruck aber auch in einem breiteren Sinne einer allgemeinen Strahlformänderung, z.B. einer Strahlaufweitung, gebraucht (divergierender Strahl). Der jeweilige Sinn erschließt sich für einen Fachmann auf dem Gebiet der Optik ohne weiteres.

Unter "Kollimation" versteht die Erfindung in der Regel eine Parallelisierung des Strahls. Auch dieser Ausdruck wird jedoch in manchen Zusammenhängen der Erfindung breiter gebraucht, die der einschlägig vorgebildete Fachmann ohne weiteres erkennt.

Eine Spiegelung an einer reflektiv wirksamen Grenzfläche kann dabei allein aufgrund der genannten Brechungsindex-Differenz bewirkt werden; alternativ kann die entsprechende Fläche eine Außenfläche des Umlenkelements sein, die z.B. eine mit einem spiegelnden Metall beschichtete Fläche ist.

Durch die Aufteilung der Funktionen Umlenkung und Fokussierung auf zwei nicht identische Flächen können erfindungsgemäß die Strahlhöhe und der Durchmesser des Strahls unabhängig voneinander festgelegt werden. Darüber hinaus kann die Optik eine bessere Abbildungsleistung erhalten, falls das mikrooptische Bauelement mindestens zwei Flächen mit Brechkraft aufweist. Die Verbesserung kann insbesondere in
- einer höheren Gesamt-Brechkraft des Systems,
- einer höheren Toleranz gegen Fertigungstoleranzen,
- einer Farbkorrektur z.B. durch Kombination eines diffraktiven optischen Elements (DOE) und einer Linse, und/oder
- einem Ausgleich von Positionierfehlern des Umlenkelements auf dem Substrat bzw. auf dem Strahlungsausgangs-/-eingangselement durch eine für endliche Felder korrigierte Optik
bestehen.

Nachstehend soll die Erfindung anhand der Strahlführung solcher Ausführungsformen näher erläutert werden, bei denen das optische Bauelement ein Strahlungsausgangselement aufweist, auf dem das Strahlumlenkelement angeordnet ist. Dabei tritt die Strahlung ausgehend von dem Strahlungsausgangselement in das Strahlumlenkelement ein, wird dort umgelenkt und bildet dabei einen Strahl, der gegenüber dem Austrittswinkel, den der das Strahlungsausgangselement verlassende Strahl mit der Substratoberfläche bildet, einen kleineren oder sogar negativen Winkel besitzt oder parallel zur Substratoberfläche ausgerichtet ist. Der durch das Umlenkelement geformte Strahl kann ein paralleles oder fokussiertes (d.h. ggf. auch aufgeweitetes) Strahlenbündel sein.

Es sollte aber klar sein, dass die Erläuterungen zu diesen Ausführungsformen vice versa auch für solche Ausführungsformen gelten, in denen ein Strahl von außen auf das Strahlumlenkelement auftrifft und in ein auf dem Substrat angeordnetes Strahlungseingangselement geleitet (eingekoppelt) wird. In diesen Fällen wird der auftreffende Strahl derart umgelenkt und so fokussiert, dass er in das Strahlungseingangselement eintreten kann.

Das Substrat kann ein beliebiges Substrat sein, wie es für optische bzw. photonische Zwecke in gängiger Weise eingesetzt wird, z.B. eine Leiterplatte, ein starres oder flexibles Substrat, z.B. eine Folie, insbesondere aus einem organischen Polymer, oder ein Chip, beispielsweise ein Siliziumchip, ein InP-Chip oder ein Triplex-Chip. Auf einer Oberfläche dieses Substrats befindet sich mindestens ein Strahlungsausgangselement oder Strahlungseingangselement. Das Strahlungsausgangselement kann ausgewählt sein unter aktiven Elementen, wie Lichtemittern (z.B. Lasern, VCSELn, LEDs), und passiven Elementen, die ihnen zugeführtes Licht weiterleiten, z.B. Gittern zur Lichtauskopplung oder (Glas-) Umlenkspiegeln im Substrat. Das Strahlungseingangselement kann ebenfalls ausgewählt sein unter aktiven Elementen (z.B. Sensoren, Detektoren) und passiven Elementen wie Gittern zur Lichteinleitung oder Umlenkspiegeln im Substrat. In jedem Fall ist den erfindungsgemäß verwendeten Strahlungsausgangs- und -eingangselementen gemeinsam, dass sie Licht senkrecht oder im Wesentlichen senkrecht zur Oberfläche oder unter kleinen Winkeln zum Lot, bevorzugt unter 20°, besonders bevorzugt kleiner oder gleich 10°, des Substrats ein- oder auskoppeln. In Einzelfällen sind Substrat und Strahlungsausgangselement identisch, beispielsweise im Falle einer LED, die gleichzeitig als Substrat dient und Licht emittiert. Das Substrat kann gegebenenfalls mindestens zwei Strahlungsausgangselemente oder mindestens zwei Strahlungseingangselemente oder mindestens ein Strahlungsausgangselement und ein Strahlungseingangselement aufweisen. Die erfindungsgemäß eingesetzten Bauteile lassen sich vorzugsweise der Mikrooptik zuordnen, haben also möglichst geringe Abmessungen.

Unmittelbar auf dem oder auf zumindest einem der Strahlungsausgangs-/-eingangselemente ist das erfindungsgemäße Strahlumlenkelement angeordnet, und zwar in der Regel so, dass es mit einer ebenen Fläche an die oder eine ebene Oberfläche des Strahlungsausgangs-/-eingangselements anschließt und meist über diese etwas herausragt.

Das Strahlumlenkelement ist aus einem oder mehreren Materialien gebildet, die einen für die gewünschten Zwecke geeigneten Brechungsindex aufweisen. Häufig und in günstiger Weise liegt dieser bei 1,50 oder darüber, teilweise jedoch auch darunter. Die hierfür geeigneten Materialien und Herstellungsmöglichkeiten sind weiter unten angegeben. Die Größe wird ebenfalls dem Zweck nach in geeigneter Weise gewählt; es ist aber anzumerken, dass die Erfindung die Verwendung sehr kleiner Strahlumlenkelemente ermöglicht, die beispielsweise Abmessungen im Bereich von unter ca. 500 µm Höhe, vorzugsweise von unter ca. 300 µm, besitzen. Beispielhafte Strahlumlenkelemente besitzen in den nachstehend näher erläuterten "einfachen" Formen Abmessungen von ca. 200 µm oder darunter, teils sogar nur ca. 100 µm Höhe und ca. 150 µm Breite, die "zusammengesetzten" Formen besitzen eine ähnliche Höhe, aber eine größere Breite. Aufgrund der geringen Höhe des erfindungsgemäßen Strahlumlenkelements ist die Erzeugung von optischen Bauelementen möglich, die extrem wenig Platz beanspruchen, aus den oben genannten Gründen jedoch eine extrem genaue Lichtleitung und -steuerung ermöglichen.

In allen Ausführungsformen der Erfindung ist das Strahlumlenkelement so geformt, dass die aus dem Strahlungsausgangselement austretende elektromagnetische Strahlung (die in der Regel einen Strahlwinkel von ca. 7-10° aufweist) (meist, aber nicht immer, zuerst) auf eine ebene oder gekrümmte Grenzfläche des Strahlumlenkelements mit zumindest teilweise reflektiven Eigenschaften trifft. Diese Fläche kann eben oder gekrümmt sein, d.h. sie kann zusätzlich kollimative oder fokussierende (auch strahlaufweitende) Eigenschaften besitzen. Diese Fläche ist in der Regel eine Außenfläche des Strahlumlenkelements, die optional zur Verbesserung der Reflexionswirkung verspiegelt sein kann. In einer speziellen Ausgestaltung der Erfindung dient diese Fläche als Strahlteiler, d.h. ein Teil der Strahlung wird reflektiert, ein anderer tritt unter Brechung an dieser Stelle aus dem Strahlumlenkelement aus. In einer alternativen, ebenfalls speziellen Ausgestaltung der Erfindung ist diese Fläche diffraktiv, d.h., sie kann z.B. als Gitter oder als Phasenplatte ähnlich einer Fresnelschen Zonenplatte oder als DOE ausgebildet sein oder die Form einer volumenstrukturierten Brechzahlmodulation (Hologramm, Metamaterial) haben.

Beim Auftreffen der Strahlung auf diese voranstehend beschriebene die Strahlung beeinflussende und optisch wirksame Fläche wird zumindest ein Teil davon ins Innere des Strahlumlenkelements geführt.

Trifft der Strahl zuerst auf diese Fläche, wird der ins Innere gelenkte Teil erfindungsgemäß spätestens beim endgültigen Verlassen des Strahlumlenkelements nochmals umgeformt. Dies geschieht häufig über ein linsenförmiges Element, wobei entweder die (bzw. im Falle von unten näher beschriebenen mehrteiligen Strahlumlenkelementen: die letzte) Austrittsfläche des Strahlumlenkelements gekrümmt ist und/oder der Strahl durch eine im Inneren des Elements angeordnete Linse aus einem Material mit anderem Brechungsindex hindurchgeführt wird. Die Krümmung der Linse kann in Kombination mit der Brechzahldifferenz zwischen dem Material des Umlenkelements und dem der äußeren Umgebung so gewählt werden, dass ein paralleles Strahlenbündel, ein konvergierender oder ein divergierender Strahl aus dem Element austritt. In einer ersten Alternative dazu handelt es sich um eine nicht gekrümmte Austrittsfläche. Dies ist dann möglich, wenn die Brechzahldifferenz zwischen dem Material des Umlenkelements und dem der äußeren Umgebung in Kombination mit dem Winkel, mit dem der Strahl auf diese Fläche auftrifft, eine zusätzliche Umlenkung, beispielsweise eine (stärkere) Konvergenz des Strahlungsbündels im Vergleich zu dessen Form im Inneren des Umlenkelements bewirkt. In anderen, spezifischen Ausgestaltungen wird der Strahl im Inneren des Umlenkelements über ein diffraktives optisches Element, eine Linse, eine Linsenkombination, ein Flächenhologramm, ein Volumenhologramm, ein Metamaterial (ein mikroskopisch auf Wellenlängen- oder sub-Wellenlängen-Skala strukturiertes Material) oder eine Kombination aus mehreren der genannten Elemente strahlgeformt bzw. fokussiert. Dieses Element kann alternativ oder zusätzlich eine wellenlängenabhängige optische Wirkung haben.

In manchen Ausgestaltungen der Erfindung wird der Strahl zuerst durch das vorgenannte Element bzw. die entsprechende Elementkombination geführt und trifft erst dann auf die weiter oben beschriebene ebene oder gekrümmte Grenzfläche des Strahlumlenkelements mit zumindest teilweise reflektiven Eigenschaften.

In einer spezifischen Ausgestaltung der Erfindung ist das Strahlumlenkelement zwei- oder mehrteilig ausgebildet, wobei ein erster Teil wie oben für das gesamte Strahlumlenkelement beschrieben unmittelbar auf dem oder auf mindestens einem der Strahlungsausgangs-/-eingangselemente angeordnet ist und meist über dieses etwas hinausragt. Ein zweiter Teil ist an einer Position auf der Oberfläche des Substrats angeordnet derart, dass er sich zwingend unmittelbar im Strahlengang der aus dem ersten Teil austretenden Strahlung (oder zumindest einem Teil davon) befindet. In diesen Ausgestaltungen der Erfindung sind die mindestens zwei den Weg der durch das Element hindurchtretenden Strahlung beeinflussenden Flächen auf die beiden Teile aufgeteilt, so dass der auf dem Strahlungsausgangs-/-eingangselement befindliche Teil (in den meisten Fällen) diejenige Fläche aufweist, die die Umlenkung mindestens eines Teils der einfallenden Strahlung bewirkt, während sich die andere Fläche, die eine Änderung des Strahldurchmessers bewirkt, am zweiten Teil des Umlenkelements befindet (in den selteneren Fällen jedoch umgekehrt). Insbesondere kann in diesen Ausgestaltungen der erste Teil des Umlenkelements sehr einfach, mit ausschließlich planen Flächen, gebildet sein, deren eine der Strahlbrechung dient wie oben beschrieben. Der zweite Teil kann dann z.B. eine ggf. auf einem geeigneten Hals sitzende Linse oder eine entsprechende Linsenabfolge sein, die den aus dem ersten Teil austretenden Strahl formt. Dieser kann als Parallelstrahl, als konvergierender Strahl oder als divergierender Strahl aus der einzigen Linse oder der letzten Linse der Linsenabfolge austreten.

In einer anderen, davon unabhängigen spezifischen Ausgestaltung der Erfindung befinden sich ein Strahlungsausgangselement sowie ein Strahlungseingangselement auf der Oberfläche des Substrats. Auf beiden Elementen ist je ein Strahlumlenkelement angeordnet, wobei die beiden Umlenkelemente so zueinander ausgerichtet sind, dass der aus dem einen Strahlumlenkelement austretende Strahl in das andere Strahlumlenkelement eintritt. In dieser Variante ist es bevorzugt, dass der aus dem ersten Strahlumlenkelement austretende Strahl ein paralleles Strahlenbündel darstellt. Die beiden Umlenkelemente können eine identische Geometrie aufweisen, ohne dass dies ein notwendiges Kriterium wäre, und sind damit in der Lage, die aus dem Strahlungsausgangselement emittierte Strahlung in das Strahlungseingangselement zu führen.

In einer spezifischen Variante zu dieser Ausgestaltung sind die beiden Strahlumlenkelemente auf Strahlungseingangs- bzw. -ausgangselementen angeordnet, die sich nicht auf derselben Substratoberfläche befinden, sondern auf z.B. den Substraten von zwei nebeneinander angeordneten optischen Bauelementen, die ihrerseits auf einem z.B. weitere elektrische und/oder optische Komponenten aufweisenden Chip oder sonstigen Substrat befestigt sind. Die Umlenkelemente dienen in dieser spezifischen Variante der Einleitung von Licht, das aus dem ersten optischen Element austritt, in einen Detektor oder ein Gitter zur Lichteinkopplung auf dem zweiten optischen Element. Auch in dieser Variante können die beiden Umlenkelemente geometrisch identisch oder unterschiedlich sein.

Bei den voranstehend erläuterten Ausführungsformen der Erfindung handelt es sich um Strahlumlenkelemente, die vorliegend als "einfach" bezeichnet werden. Die Erfindung umfasst darüber hinaus sogenannte "zusammengesetzte Elemente". Darunter sind nicht die oben beschriebenen mehrteiligen Elemente zu verstehen, sondern Elemente, die die notwendigen Funktionen und Geometrien der "einfachen Elemente" doppelt aufweisen, und zwar häufig, aber nicht zwingend notwendig, in spiegelsymmetrischer Form. Sie lassen sich daher formal aus zwei "einfachen" Elementen zusammengesetzt definieren.

In einer spezifischen Ausgestaltung wird ein zusammengesetztes Element bereitgestellt, das auf einem Strahlungsausgangselement und einem Strahlungseingangselement angeordnet ist wie für die "einfachen" Elemente beschrieben. In diesen Fällen trifft das das Ausgangselement verlassende Strahlungsbündel vorzugsweise auf eine erste, ebene oder gekrümmte Grenzfläche des Strahlumlenkelements mit zumindest teilweise reflektiven Eigenschaften. Diese Fläche ist in der Regel eine Außenfläche des Strahlumlenkelements, die optional zur Verbesserung der Reflexionswirkung verspiegelt sein kann. In einer speziellen Ausgestaltung der Erfindung dient diese Fläche als Strahlteiler, d.h. ein Teil der Strahlung wird reflektiert, ein anderer tritt unter Brechung an dieser Stelle aus dem Strahlumlenkelement aus. In einer alternativen, ebenfalls speziellen Ausgestaltung der Erfindung ist diese Fläche diffraktiv, d.h., sie ist z.B. als Phasenplatte, Gitter oder DOE, ausgebildet.

Beim Auftreffen der Strahlung auf diese voranstehend beschriebene die Strahlung beeinflussende und optisch wirksame Fläche wird zumindest ein Teil davon ins Innere des Strahlumlenkelements geführt. In der einfachsten Form dieser Ausführungsform ist die Spiegelfläche gekrümmt und gibt dem Strahl die Form eines parallelen Strahlenbündels, das parallel zur Substratoberfläche im Strahlumlenkelement verläuft, bis es auf eine gegenüberliegende, optional verspiegelte Außenfläche dieses Elements trifft, welche dieselbe Geometrie wie die erste Außenfläche besitzt. Diese reflektiert und kollimiert oder fokussiert den Strahl in Richtung des Strahlungseingangselements. Damit dient dieses zusammengesetzte Element dazu, die aus dem Strahlungsausgangselement emittierte Strahlung in das Strahlungseingangselement zu führen.

In einer weniger einfachen Form dieser Ausführungsform trifft der Strahl im Inneren des Strahlumlenkelements auf eine zweite, den Strahldurchmesser ändernde Fläche. Diese ist vorzugsweise Teil einer Linse aus einem Material, das sich vom übrigen Material des Elements unterscheidet und einen anderen Brechungsindex als dieses aufweist, wobei der Strahl auf der anderen Seite der Linse wieder austritt. Durch die Linse kann beispielsweise ein aus dem Spiegel austretender, divergierender Strahl fokussiert werden. Dieser Strahl wird dann an die gegenüberliegende Spiegelfläche geführt wie oben für die "einfachen Elemente" beschrieben, und tritt schließlich in das Strahlungseingangselement ein.

Anstelle der in das Strahlumformelement eingebetteten Linse kann auch eine Abfolge von Linsen oder ein anderes optisches Element vorgesehen sein, zum Beispiel eine Fresnelsche Zonenplatte, ein Gitter, ein diffraktives optisches Element, ein Flächenhologramm, ein Volumenhologramm oder ein Metamaterial.

In einer nochmals anderen Gestaltung dieser Ausführungsform dient das zusammengesetzte Element nicht als Strahlführung für aus dem Strahlungsausgangselement austretende Strahlung zu einem Strahlungseingangselement auf demselben Substrat, sondern zu einem Strahlungseingangselement auf einem zweiten Substrat. Hinsichtlich der Wirkung kann auf die oben beschriebene Ausgestaltung verwiesen werden, bei der zwei einander zugewandte Strahlumlenkelemente auf verschiedenen Substraten angeordnet sind.

Auch in diesen Ausgestaltungen der Erfindung kann der Strahl zuerst durch das vorgenannte Element bzw. die entsprechende Elementkombination geführt werden und trifft erst dann auf die ebene oder gekrümmte Grenzfläche des Strahlumlenkelements mit zumindest teilweise reflektiven Eigenschaften. Ein zweites solches Element bzw. eine solche Elementkombination kann vorgesehen sein; sie kann aber auch weggelassen werden.

In einer Reihe von Ausführungsformen der Erfindung besitzt das Strahlumlenkelement Ausnehmungen oder Hinterschneidungen. Solche Gestaltungen sind mit den bisher für Strahlumlenkelemente vorgeschlagenen Fertigungsverfahren nicht realisierbar. Eine Reihe der erfindungsgemäß einsetzbaren Herstellungsverfahren kann jedoch genutzt werden, um solche Gestaltungen zu erhalten.

Hinterschneidungen werden z.B. benötigt, wenn das Strahlumlenkelement eine linsenförmige vertikale Austrittsfläche aufweist. Alle zusammengesetzten Elemente besitzen in günstiger Weise eine Ausnehmung im Bereich zwischen den Flächen, mit der diese Elemente auf dem Strahlungseingangselement und auf dem Strahlungsausgangselement aufliegen. Dieser Bereich wird nicht für die Strahlführung benötigt, die Ausnehmung spart Material und erleichtert eine saubere Positionierung. Weiterhin sind in diesen Ausführungsformen zusätzliche Oberflächen verfügbar, die gekrümmt ausgeführt werden können und über ihre Brechkraft zur Strahlformung genutzt werden können, oder allgemein eine optische Funktionalität tragen. Vergleichbares gilt für Strahlumlenkelemente mit zusätzlichen optischen Elementen, die häufig eine Verlängerung des Umlenkelements in (meist zur Substratoberfläche im Wesentlichen parallelen) Strahlrichtung nach sich ziehen: Auch hier wird der der Substratoberfläche zugewandte Bereich des Umlenkelements nicht für optische Zwecke benötigt.

Der aus dem Strahlumlenkelement austretende Strahl kann aufgrund der Vielzahl der möglichen geometrischen Formen und Brechzahldifferenzen beliebig geformt sein; er kann divergent oder konvergent sein und im Rahmen der möglichen Geometrie einen beliebigen Durchmesser aufweisen. Auch das Strahlprofil und die Wellenfront sind geometrisch nicht beschränkt. Darüber hinaus kann der Strahl aufgeteilt werden, wobei eine Strahlteilung in zwei oder mehr parallele oder in verschiedene Raumrichtungen weisende Teilstrahlen möglich ist; umgekehrt können mehrere Strahlen zusammengeführt werden (Multiplexing). Eine Strahlteilung kann dabei gegebenenfalls auch nach Wellenlängen erfolgen.

Häufig wird das erfindungsgemäße Strahlumlenkelement eingesetzt, um Strahlung aus einem Strahlungsausgangselement in einen Wellenleiter (Lichtleiter) zu führen (oder vice versa). Dieser kann direkt an einer (dann meist ebenen) Fläche des Strahlumlenkelements ansetzen; der Lichtstrahl kann aber auch vor dem Auftreffen auf dem Eingang des Lichtleiters durch ein Zwischenmedium, beispielsweise Luft oder ein Einbettmaterial, geführt werden. Die Strahlung kann beliebige Wellenlängen des elektromagnetischen Spektrums aufweisen; häufig wird mit Wellenlängen von 1550 oder 1310 nm, des Weiteren auch im Sichtbaren oder bei 850 nm, gegebenenfalls auch 980 nm gearbeitet. Materialien, die bei diesen Wellenlängen hochtransparent sind, sind bekannt und werden bereits vielfach eingesetzt. Das erfindungsgemäße Strahlumlenkelement kann dabei insbesondere für die folgenden Aufgaben genutzt werden:
(a) Auskopplung und Kollimation von Licht aus einem Gitterkoppler auf einem photonischen Chip in eine Faser
(b) Auskopplung und Kollimation von Licht aus einem aktiven elektrooptischen Lichtemitter in eine Faser
(c) Auskopplung und Fokussierung zu konvergentem Licht sowie Einkopplung in eine Faser (aus Gitterkoppler auf einem photonischen Chip)
(d) Auskopplung und Fokussierung zu konvergentem Licht sowie Einkopplung in eine Faser (aus aktivem elektrooptischen Lichtemitter)
(e) Auskopplung von Licht aus einem VCSEL und Fokussierung auf einen Detektor
(f) Kopplung von Licht aus einem Gitter auf einem photonischen Chip in ein anderes Gitter auf demselben photonischen Chip
(g) Kopplung von Licht aus einem Gitter auf einem photonischen Chip in ein anderes Gitter auf einem anderen photonischen Chip
(h) Einkopplung von kollimiertem Licht aus einer Faser in einen Detektor
(i) Einkopplung von kollimiertem Licht aus einer Faser in ein Gitter
(j) Einkopplung von divergentem Licht aus einer Faser in einen Detektor
(k) Einkopplung von divergentem Licht aus einer Faser in ein Gitter.

Das Strahlumlenkelement der vorliegenden Erfindung kann aus verschiedenen optisch geeigneten Materialien hergestellt sein, die insbesondere auch hoch transmittiv für die obigen Wellenlängen sind und damit ein nur sehr geringes Dämpfungsverhalten zeigen. Hierzu gehören Gläser, organische Polymere sowie anorganisch-organische Hybridpolymere, die neben organisch polymerisierten Gruppen meist ein anorganisches Netzwerk aus Si-O-Si-Bindungen enthalten, worin ein Teil der Si-Atome durch andere Metallatome ersetzt sein kann. Derartige Hybridpolymere sind im Stand der Technik bekannt. Je nach Herstellungstechnik können auch andere Materialen verwendet werden. Diese Materialien haben vorzugsweise Brechungsindizes im Bereich zwischen 1,3 und 1,6, wobei vor allem manche rein organische Materialien relativ niedrige Brechunsindizes haben können, während anorganisch-organische Hybridmaterialien je nach (spezifisch anpassbarer) Ausgestaltung in der Regel Brechungsindizes zwischen 1,40 und 1,9 aufweisen, bevorzugt 1,45 bis 1,6. Gläser können ggf. sogar noch höhere Brechungsindizes besitzen, z.B. wenn sie schwerere Metallionen wie Titan enthalten.

Aus dem Stand der Technik ist es bekannt, Strahlumlenkelemente separat zu fertigen, beispielsweise aus einem prägbaren Material. Die Prägung kann direkt auf dem optischen Bauelement vorgenommen werden; es eignen sich hierfür Polymere, die nachverfestigt werden können, wie aus WO 2007/128021 A1 oder US 8,876,408 B2 bekannt. Alternativ kann das Umlenkelement separat gefertigt werden, beispielsweise aus Glas oder einem Polymer, und anschließend am gewünschten Platz montiert werden, z.B. durch Verkleben.

Eine weitere Möglichkeit besteht in der Herstellung mittels Lasersintern von SiOₓ-Pulver im 3D-Druck, oder mittels 3D-Druck mit organischen Polymeren oder anorganisch-organischen Hybridpolymeren. Hierbei wird in der Regel nach jedem Schichtauftrag oder nach Abschluss des Materialauftrags eine (in manchen Fällen auch strukturierende) Verfestigung mit Licht (z.B. UV-Licht) durchgeführt. Zusätzlich können Temperschritte genutzt werden, um das Gesamtvolumen vor- oder nachzuverfestigen. Der dabei entstehende Glas- oder Polymerkörper kann anschließend ggf. poliert werden.

Günstig ist der Einsatz von photostrukturierbaren Materialien. Dies können beispielsweise organische Polymere wie Additionspolymere (Acrylate, Methacrylate, Vinyl-, allyl- oder styrylgruppenhaltige Polymere oder Epoxid-Polymere), oder anorganisch-organische Hybridpolymere sein, die ein anorganisches Netzwerk (meist mit Si-O-Si-Brücken, worin ein Teil der Si-Atome durch andere Metallatome ersetzt sein kann) sowie organisch vernetzte Gruppen (z.B. Vinyl-, Allyl-, Styryl-, Acrylat-, Methacrylatgruppen, Norbornengruppen, vernetzte Epoxygruppen) aufweisen. Solche Materialien sind beispielsweise in WO 03/031499 A2 offenbart; sie besitzen wie oben erwähnt häufig einen Brechungsindex von 1,50 oder darüber, also einen für die Zwecke der Erfindung sehr günstigen Wert. Wegen der hohen Variabilität der anorganisch und organisch vernetzten Hybridpolymere lassen sich jedoch auch niedrigere Brechungsindizes einstellen. Aufgrund der Photostrukturierbarkeit können sowohl die rein organischen als auch die anorganisch-organischen Hybridmaterialien über Grautonlithographie oder Stereolithographie aus einem Badmaterial heraus strukturiert werden, wie im Stand der Technik bekannt. Hierfür sind anorganisch-organische Hybridpolymere besonders günstig, weil sie in der Regel über eine hydrolytische Kondensationsreaktion der monomeren Ausgangsverbindungen (meist Silane) erzeugt werden. Die hydrolytisch kondensierten, aber photochemisch noch unvernetzten Kondensate (meist als Harze bezeichnet) liegen häufig in flüssiger oder pastöser Form vor, so dass lösemittelfrei gearbeitet werden kann. Nach der Photostrukturierung wird in der Regel das verbliebene flüssige Material weggewaschen, d.h. das Strahlumlenkelement wird "entwickelt". Die genannten lithographischen Verfahren lassen sich aber auch mit rein organischen Materialien und photostrukturierbaren oder photothermorefraktiven Gläsern durchführen.

Wird eine Photostrukturierung wie Stereolithographie genutzt, können ggf. weitere Komponenten des optischen Bauelements auf diesem Wege erzeugt werden, beispielsweise Wellenleiter.

Wenn das photostrukturierbare Material außerdem thermisch verfestigbar ist, kann auch eine Kombination aus Photostrukturierung und thermischer Verfestigung, z.B. einer Nachverfestigung, genutzt werden, um das endverfestigte Element zu erhalten. Dies geschieht natürlich vorzugsweise nach dem Entwickeln.

Stereolithographische Verfahren liefern häufig eine hohe Oberflächen-Rauigkeit. Das kann in manchen Fällen ohne Belang sein, wenn z.B. aus optischen Gründen eine Rauigkeit von über λ/10 genügt. In anderen Fällen ist ein Nachpolieren nötig.

Allgemein sollten die erfindungsgemäßen Strahlumlenkelemente in der Regel Oberflächenrauigkeiten im Bereich von sehr fein (im einstelligen nm-Bereich) bis zu 100 nm, vorzugsweise von maximal 50 nm aufweisen.

In besonders bevorzugten Ausführungsformen der Erfindung wird das Strahlumlenkelement, ggf. zusammen mit weiteren durch diese Technik erzeugbaren Komponenten des optischen Bauelements, mit Hilfe der sogenannten 2-Photonen- oder Mehrphotonen-Absorption (TPA, MPA, engl. "Two-Photon Absorption" "Multi-Photon Absorption) erzeugt. Diese Technik ist bekannt und z.B. in WO 03/037606 A1 genauer beschrieben, und zwar dort anhand der Polymerisation von anorganisch-organischen Hybridpolymeren (organisch modifizierten, organisch polymerisierbaren Kieselsäure(hetero)polykondensaten bzw. -siloxanen). TPA/MPA kann auch zur Erzeugung von Körpern aus rein organischen, photostrukturierbaren Materialien genutzt werden. Dabei werden die Körper ganz allgemein aus einem flüssigen "Bad"-Material heraus strukturiert. Der Vorteil dieser Technik gegenüber der Stereolithographie liegt in der Möglichkeit, auch sehr kleine Körper sehr genau strukturieren und freie Formen ausbilden zu können. Hierfür geeignete Vorrichtungen und Verfahrensführungen sind in WO 2011/141521 A1 offenbart. Es lassen sich Oberflächenrauigkeiten von bis hinunter zu ca. 1-4 nm erzielen. Mit dieser Technik können Strahlumlenkelemente separat (ggf. auch gleichzeitig in vielfacher Ausführung) oder direkt an Ort und Stelle aus einem Tropfen des Ausgangsmaterials heraus auf dem optischen Bauelement erzeugt werden; gleichzeitig lassen sich ggf. weitere optische Komponenten aus demselben Tropfen erzeugen, beispielsweise Wellenleiter.

Auch manche Gläser sind photostrukturierbar; diese verändern durch Belichtung ihre chemischen Eigenschaften, z.B. ihre Löslichkeit. So ist es möglich, das belichtete Volumen nach der Photostrukturierung mit Flusssäure auszuwaschen, d.h. es handelt sich dabei um ein Negativ-Verfahren.

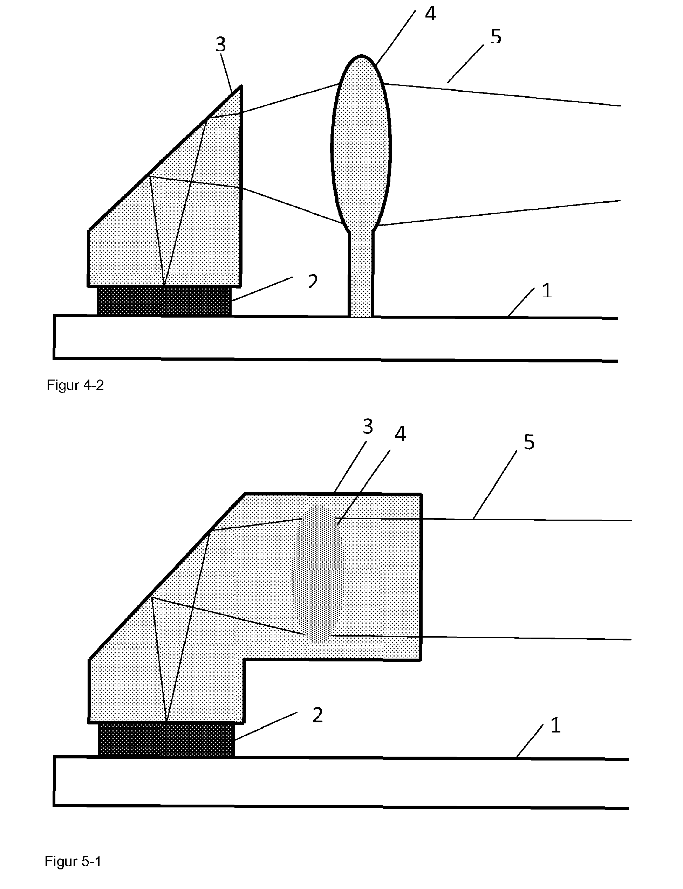

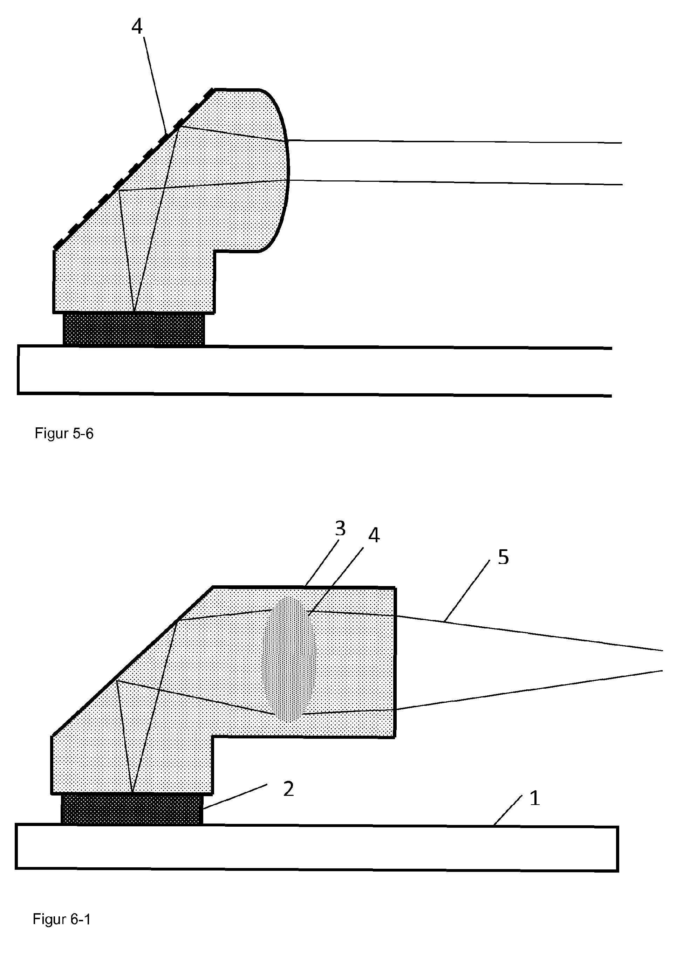

TPA- bzw. MPA-Prozesse können auch angewendet werden, um Ausführungsformen des Strahlumlenkelements zu erzeugen, die eine innenliegende oder außenliegende Linse besitzen, wie unten z.B. anhand der Grundform E (Fig. 5-1) gezeigt. Diese Linse kann z.B. aus Glas bestehen und im TPA/MPA Prozess (in diesem Fall aus einem separaten Bad heraus) als Träger für das Verfestigen des photostrukturierbaren Materials dienen.

Sofern das eingesetzte Ausgangsmaterial sowohl photochemisch strukturiert als auch thermisch verfestigt werden kann, ist es möglich, das Strahlumlenkelement als Formkörper mit zwei Bereichen unterschiedlicher Primärstruktur (d.h. mit Bereichen, die sich durch unterschiedliche chemische Verknüpfungen, welche z.B. den Vernetzungsgrad beeinflussen, oder aufgrund von erfolgten Umordnungen oder Umlagerungen unterscheiden) und/oder unterschiedlicher Sekundärstruktur (hierunter wird die Ordnung der Moleküle im Formkörperverbund verstanden, die z.B. durch Faltungen oder Verdichtungen beeinflusst wird) auszugestalten, wobei die unterschiedlichen Primär- und/oder Sekundärstrukturen zum Beispiel unterschiedliche Brechungsindizes aufweisen können. Die entsprechenden Techniken sind z.B. in WO 2014/108546 A2 und WO 2014/108538 A2 beschrieben: Das Objekt, vorliegend das Strahlumlenkelement, wird in die geeignete (äußere) Form gebracht und vorzugsweise thermisch (in manchen Fällen auch durch Flutlicht) vorverfestigt, danach wird mittels Laser und TPA/MPA eine Innenstruktur mit unterschiedlicher Primär- und/oder Sekundärstruktur erzeugt ("eingeschrieben"), und schließlich kann auf Wunsch zusätzlich eine Endverfestigung durchgeführt werden, die zwingend ist, sofern keine Vorverfestigung stattfand. Überraschend dabei ist, dass sich auch thermisch bereits vorverfestigtes Material durch TPA/MPA weiter bearbeiten und beeinflussen lässt, auch wenn man annehmen muss, dass bei der thermischen Vorverfestigung die mögliche Polymerisationsreaktion bereits vollständig abläuft. Dennoch verändert sich an den Orten (Voxeln), an denen Laserlicht mit einer solchen Intensität eingestrahlt wird, dass TPA/MPA möglich ist, das Material; insbesondere erhält es dabei einen anderen Brechungsindex. Dieses Verfahren eignet sich für die Herstellung von allen solchen Varianten des erfindungsgemäßen Strahlumlenkelements, in deren Inneres eine zweidimensionale Fläche, z.B. ein Gitter, oder ein Volumenelement eingeschrieben ist, beispielsweise eine Linse, die jeweils den Strahlengang der hindurchtretenden Strahlung beeinflussen, sei es durch Spiegelung, Aufsplittung des Strahls in unterschiedliche Wellenlängen oder Aufsplittung eines Strahls mit unterschiedlichen Wellenlängen in unterschiedliche Pfade für jede einzelne Wellenlänge, oder einen Wellenleiter, der um 90° gewinkelt ist und in der Biegung eine photonische Struktur, wie z.B. einen photonischen Kristall, enthält, oder anderes.

In einer anderen Variante der Erfindung kann das Strahlumlenkelement mit diesem Verfahren integriert in eine feste Umgebung erzeugt werden. Hierfür wird der Bereich auf dem optischen Bauelement, der mit diesem festen Material versehen werden soll und mindestens ein Strahlungseingangs- oder -ausgangselement aufweist, mit einem thermisch verfestigbaren und photostrukturierbaren flüssigen Material versehen, das anschließend durch Fluten mit Licht oder thermisch vorverfestigt wird. Anschließend wird in diesem Festkörper das Strahlumlenkelement auf dem Strahlungseingangs- oder -ausgangselement mittels TPA/MPA strukturiert. Eine Nachverfestigung kann sich anschließen wie im voranstehenden Absatz beschrieben.

Die Erzeugung von Wellenleitern mittels TPA ist bekannt; sie wird auch in WO 2007/128021 A1 für die dortigen Elemente vorgeschlagen. Erfindungsgemäß ist es selbstverständlich möglich, neben dem Strahlumlenkelement oder Teilen davon wie oben beschrieben auch ggf. vorhandene Wellenleiter durch TPA-Strukturierung zu erzeugen. Dies kann ggf. im selben Verfahrensschritt erfolgen. Dabei kann entweder nur der Wellenleiter als solcher direkt in einer festen Umgebung erzeugt werden wie im voranstehenden Absatz für das Strahlumlenkelement beschrieben, wobei das umgebende Material als Cladding fungiert, oder aber auch das Strahlumlenkelement wird in das feste Material mit eingebettet. Dabei kann der Wellenleiter insbesondere dann, wenn die Strahlaustrittsfläche des Strahlumlenkelements eben ist, direkt an diese anstoßend ausgebildet werden; alternativ kann ein Abstand zwischen den beiden Elementen bestehen, den der Lichtstrahl überbrückt (das Medium im zwischenliegenden Raum kann je nach Ausgestaltung Luft oder ein anderes gasförmiges Umgebungsmedium oder ein festes Material sein, beispielsweise dasjenige, aus dem auch das Umlenkelement und/oder der Wellenleiter erzeugt wurde(n) wie voranstehend beschrieben).

Nachstehend soll die Erfindung anhand von spezifischen Beispielen näher erläutert werden. Darin wird in der Regel der Strahlengang anhand des Wegs eines ein Strahlungsausgangselement verlassenden Strahls oder Strahlenbündels beschrieben; es sollte aber klar sein, dass der Strahlengang selbstverständlich auch die umgekehrte Richtung haben und in ein entsprechendes Strahlungseingangselement eintreten kann. Zu sehen ist in allen Figuren ein Substrat (z.B. ein photonischer Chip), auf dessen Oberfläche 1 ein Strahlungsausgangs- (bzw. -eingangs-) -element 2 angeordnet ist. Das Element 2 kann auch selbst als Substrat wirken, in diesem Fall sind 1 und 2 identisch. Wie oben erläutert, besitzt das Strahlenbündel eines derartigen Elements in der Regel einen Strahlwinkel von ca. 7-10°. Das Strahlumlenkelement ist in allen Fällen direkt auf dem Strahlungsausgangs-/-eingangselement 2 angeordnet.

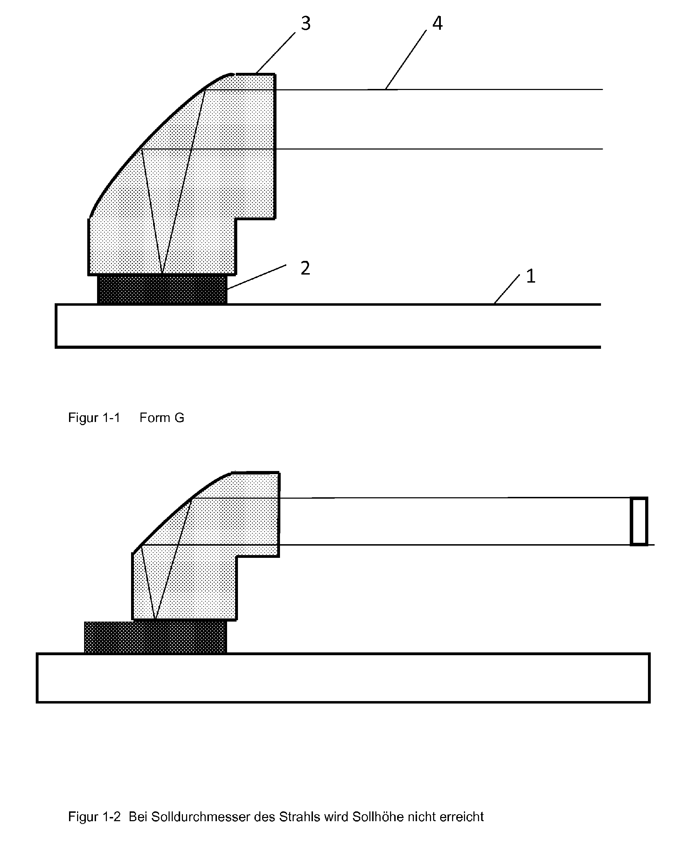

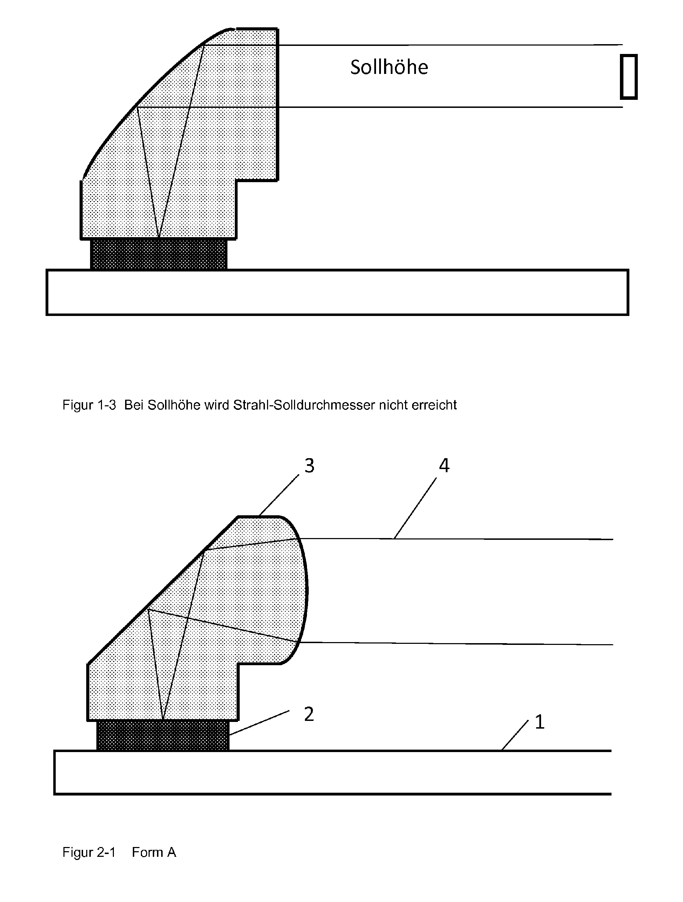

In **Figur 1-1** ist eine Ausgestaltung eines mikrooptischen Bauelements mit der Grundform (Form G) eines Strahlumlenkelements dargestellt, die ein aus dem Stand der Technik bekanntes Prinzip der Strahlumlenkung nutzt. Das Strahlumlenkelement 3 besitzt eine gekrümmte Fläche, die für die aus dem Strahlungsausgangselement austretende Strahlung als fokussierender Spiegel (Spiegel plus Linse) wirkt. Der über diesen Spiegel kollimierte Lichtstahl tritt über eine weitere Fläche des Umlenkelements, die er senkrecht zur Flächenebene passiert und die deshalb keinen Einfluss auf die Strahlform nimmt, aus dem Element 3 aus und tritt hier in den freien Raum. Im Stand der Technik werden solche Strahlumlenkelemente aber auch in ein festes Material eingebettet, dessen Brechungsindex sich von dem des für das Strahlumlenkelement verwendeten Materials unterscheidet. Der Strahlengang ändert sich hierdurch nicht. Das gezeigte Strahlumlenkelement besitzt eine materialsparende Hinterschneidung unterhalb der Strahlaustrittsfläche, die sich mit den bisherigen Herstellungsverfahren für derartige Elemente nicht realisieren ließ. Die Form des Strahlumlenkelements ist daher neu. Die Hinterschneidung hat jedoch keine Bedeutung für den Strahlengang.

Die **Figuren 1-2** **und** **1-3** machen die technischen Grenzen eines solchen Strahlumlenkelements deutlich: wie vorstehend ausführlich erläutert, ist die Nutzung einer einzigen Fläche für das Umlenken und das Kollimieren oder sonstige Formen des Strahls mit dem Nachteil verknüpft, dass die Strahlhöhe und der Durchmesser des Strahls nicht unabhängig voneinander festgelegt werden können; bei einem gewünschten Strahldurchmesser ist automatisch die Höhe des Strahls festgelegt. Fig. 1-2 zeigt eine Ausführungsform, mit der der gewünschte schmale Solldurchmesser erreicht wird, nicht aber die Sollhöhe des kollimierten Strahls, da die Distanz zwischen der gekrümmten Fläche und der Strahlungsquelle zur Ausbildung eines schmalen Strahls klein bleiben muss. Fig. 1-3 zeigt den umgekehrten Fall: Zwar wird die Sollhöhe erreicht, nicht aber der Solldurchmesser; hier wird aufgrund des höheren Abstands zwischen der gekrümmten Fläche und der Strahlungsquelle ein zu breiter Strahl erzeugt.

Dieser Nachteil wird mit den erfindungsgemäßen Strahlumlenkelementen beseitigt, die anhand von einzelnen Ausgestaltungen nachstehend näher beschrieben werden. Die Beschreibungen zu diesen Ausgestaltungen machen deutlich, dass verschiedene Merkmale der verschiedenen Ausgestaltungen auch miteinander kombinierbar sind; diese Kombinationen sollen von der Erfindung selbstverständlich ebenfalls umfasst sein.

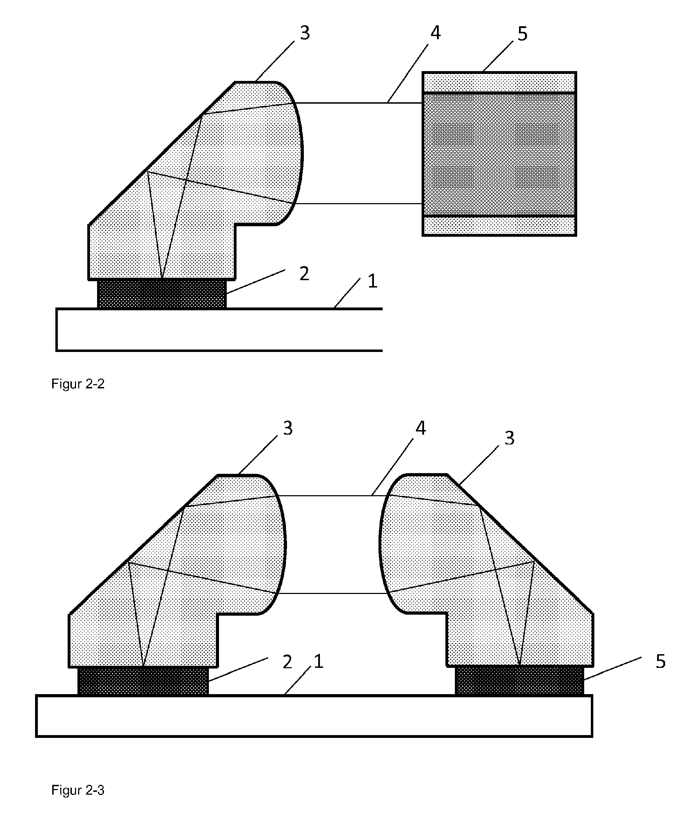

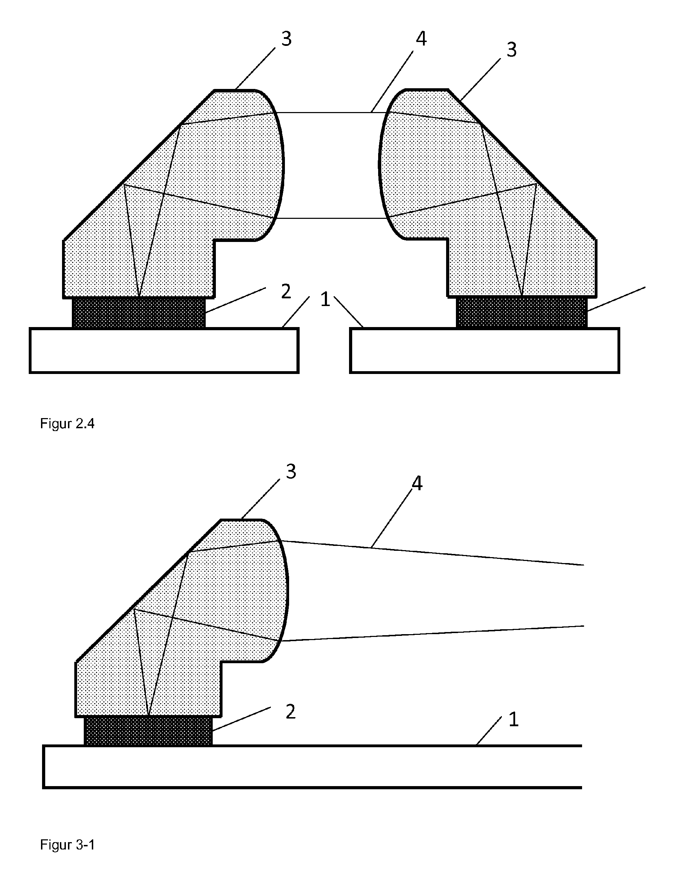

In **Figur 2-1** ist eine Grundform A eines solchen Strahlumlenkelements beispielhaft gezeigt. In dieser Grundform besitzt das Element zwei die Strahlform beeinflussende Außenflächen. Die im konkreten Fall zu wählende Geometrie hängt natürlich auch von vom Brechungsindex ab, den das Material des Strahlumlenkelements besitzt, und von der Brechzahldifferenz zum umgebenden Raum. Der die Strahlquelle 2 verlassende Strahl trifft auf eine optional (z.B. mit Metall) verspiegelte, ebene schräge (Außen-)Fläche, an der er reflektiert wird. Nach der Reflexion setzt sich innerhalb des Elements die Strahlaufweitung notwendigerweise fort. Der Strahl bewegt sich in Richtung einer zweiten ihn beeinflussenden (Außen-)Fläche, die linsenförmig gekrümmt ist. Dort wird der Strahl abgelenkt und kollimiert. Er verlässt als Parallelstrahl 4 das Umlenkelement und tritt in dieser Ausführungsform in den freien Raum (z.B. Luft, Vakuum) ein, um beispielsweise in einem bestimmten Abstand auf ein Element mit einem optischen Eingang zu treffen, beispielsweise einen Lichtleiter, einen Sensor, einen Detektor oder ein Gitter. Möglich wäre alternativ die Einbettung des Strahlumlenkelements in ein flüssiges oder festes Medium mit einem Brechungsindex, der von demjenigen des Materials des Umlenkelements abweicht. Es ist unmittelbar einsichtig, dass sich mit dieser Ausgestaltung auch bei einem nur kurzen Abstand zwischen der Strahlquelle und der spiegelnden Fläche und damit einer kompakten, gedrungenen Bauweise ein Strahl mit frei wählbarer, auch großer Breite erzeugen lässt.

**Figur 2-2** zeigt den weiteren Weg des kollimierten Lichtstrahls, hier in eine Lichtleitfaser. Diese kann aus Glas oder einem anderen transparenten Material bestehen und mit einer Claddingschicht umgeben sein. Solche Fasern lassen sich z.B. durch Strukturierung mit TPA/MPA innerhalb eines flüssigen oder vorverfestigten Materials erzeugen, wie weiter oben beschrieben. Die Lichtleitfaser kann Teil des optischen Bauelements sein, auf dem sich das Umlenkelement 3 befindet, und z.B. auf dessen Oberfläche 1 verankert sein, muss es aber nicht (sie kann zwei derartige Elemente verbinden oder das Licht zu einem anderen Objekt führen).

Eine Alternative hierzu zeigt **Figur 2-3****.** Hier wird der aus dem Umlenkelement 3 austretende, kollimierte Lichtstrahl 4 in ein Strahlungseingangselement 5 geführt, das sich auf demselben optischen Element befindet wie das Strahlungsausgangselement 2, und zwar über ein spiegelbildlich ausgebildetes und spiegelbildlich angeordnetes zweites Umlenkelement 3.

In einer Variante hierzu, die in **Figur 2-4** gezeigt ist, wird der Lichtstrahl per Freiraumpropagation bis zu einem zweiten optischen Element mit einer zweiten Substratoberfläche 1 geführt, um dort über ein spiegelbildlich ausgebildetes und spiegelbildlich angeordnetes zweites Umlenkelement 3 in ein auf der Substratoberfläche 1 des zweiten optischen Elements befindliches Strahlungseingangselement 5 einzutreten, beispielsweise einen Detektor oder ein Gitter zur Lichteinkopplung.

Sind die beiden den Weg der durch das Strahlumlenkelement hindurchtretenden Strahlung beeinflussenden Flächen Außenflächen dieses Elements, wie voranstehend für die Grundform A gezeigt, muss der das Umlenkelement 3 verlassende Strahl 4 nicht notwendigerweise parallel sein. Alternativ kann die Linse so gestaltet sein, dass er auf ein beliebiges Objekt fokussiert werden kann, wie anhand der Grundform B der **Figur 3-1** schematisch gezeigt. Es ist unmittelbar ersichtlich, dass die Geometrie des Umlenkelements und die Linsenform so gewählt werden können, dass stattdessen auch ein sich aufweitender Strahl erzeugt wird.

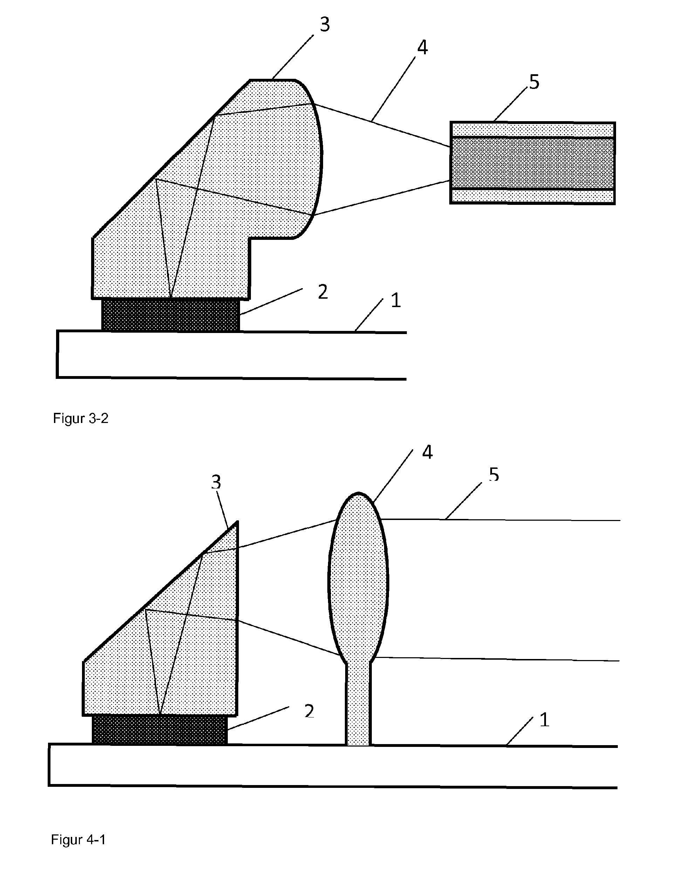

In **Figur 3-2** ist eine Variante der Grundform B gezeigt, bei der der Strahl auf den Eingang einer Lichtleitfaser fokussiert ist. Als Lichtleitfasern eignen sich wiederum Glasfasern oder z.B. durch Strukturierung mit TPA/MPA erzeugte Fasern wie für Fig. 2-2 ausgeführt. Insbesondere ist diese Ausführungsform für Single-Mode-Fasern geeignet.

**Figur 4-1** vermittelt einen Einblick in solche Ausgestaltungen der Erfindung, in denen das Strahlumlenkelement zwei- oder mehrteilig ausgebildet ist, wobei ein erster Teil unmittelbar auf dem oder auf mindestens einem der Strahlungsausgangselemente 2 angeordnet ist und meist über dieses etwas hinausragt. In der in dieser Figur gezeigten Form C besitzt der erste Teil 3 des Strahlumlenkelements eine spiegelnde Fläche wie für die Formen A und B (Fig. 2 und 3) beschrieben. Der Lichtstrahl wird beim Austritt aus diesem Teil des Umlenkelements jedoch nicht kollimiert oder fokussiert. Er tritt aus einer Fläche aus, an der er je nach Auftreffen (senkrecht zu dieser Fläche oder in einem von 90° abweichenden Winkel) unverändert bleibt oder leicht gebrochen wird. Die benötigte Kollimation erfolgt dann an einer separaten Linse 4, die beispielsweise auf einem Stiel direkt auf dem Substrat angeordnet sein kann (aber nicht muss). Der Strahl tritt durch diese Linse hindurch und wird durch sie in gewünschter Form kollimiert (parallelisiert, wie in der Fig. 4 gezeigt, oder aber auch fokussiert wie in **Figur 4-2** anhand einer als "Form D" bezeichneten Gestaltung dargestellt. Statt dessen kann der Strahl auch aufgeweitet werden.).

Die Formen C und D sind wiederum Grundformen, die vielfältig abgewandelt werden können. Beispielsweise kann anstelle einer Linse eine Schar von Linsen eingesetzt werden. Alternativ oder kumulativ ist es möglich, auch die Austrittsfläche des ersten Teils 3 des Umlenkelements linsenförmig oder konkav oder in anderer geeigneter Weise zu gestalten.

Der austretende Strahl kann in die freie Umgebung propagieren oder in ein umgebendes flüssiges oder festes Medium eintreten, wie voranstehend für die Formen A und B ausgeführt.

In **Figur 5-1** ist eine Ausgestaltung (Grundform E) gezeigt, in der die Linsenoberfläche 4 nicht eine Außenoberfläche des Strahlumlenkelements 3 ist oder in der eine separate Linse in den Strahlengang des aus einem ersten Teil des Umlenkelements kommenden Strahls angeordnet ist, sondern in der sich im Inneren des Elements eine Linse mit den Strahlengang beeinflussenden Oberflächen befindet. Dies lässt sich dadurch realisieren, dass zwei optisch ungleich dichte Materialien für die Linse und für das die Linse umgebende Material des Umlenkelements verwendet werden. Herstellen lässt sich diese Variante z.B. dadurch, dass eine Glaslinse in ein flüssiges oder pastöses organisch polymerisierbares Material eingeschlossen wird, das sodann in einer geeigneten Form auspolymerisiert wird, wobei das gebildete Polymer eine andere Brechzahl besitzt als die Glaslinse. Ein wesentlich eleganterer Herstellungsweg erfolgt über das "Einschreiben" der Linse mittels TPA/MPA. Hierfür wird das Strahlumlenkelement in seiner äußeren Form vorstrukturiert, z.B. durch Polymerisieren (durch Licht oder Wärme) in einer Form, durch ein stereolithographisches Verfahren oder ein Druckverfahren. Anschließend wird mit Hilfe eines Lasers innerhalb des vorverfestigten Materials eine 2- oder Mehr-Photonen-Polymerisation durchgeführt, wobei das Laserlicht eine zusätzliche TPA/MPA und damit eine Verfestigung (eine Änderung der Primär- bzw. Sekundärstruktur wie oben beschrieben) bewirkt. Die dadurch erzielte Brechzahldifferenz zum nicht dem Laserlicht ausgesetzten Material kann ausreichen, um eine Ablenkung des Lichtstrahls zu bewirken.

Es sollte klar sein, dass sich die Linse nicht notwendigerweise vollständig im Inneren des Umlenkelements befinden muss; stattdessen kann eine ihrer Flächen diejenige (Außen-)Fläche des Strahlumlenkelements bilden, durch die die Lichtstrahlung austritt. Das Strahlumlenkelement kann dann ggf. auch aus den zwei Komponenten aus unterschiedlichem Material assembliert sein, indem z.B. die Linse in eine konkave Ausnehmung des restlichen Strahlumlenkelements eingepasst und dort z.B. angeklebt oder auf andere Weise befestigt wird.

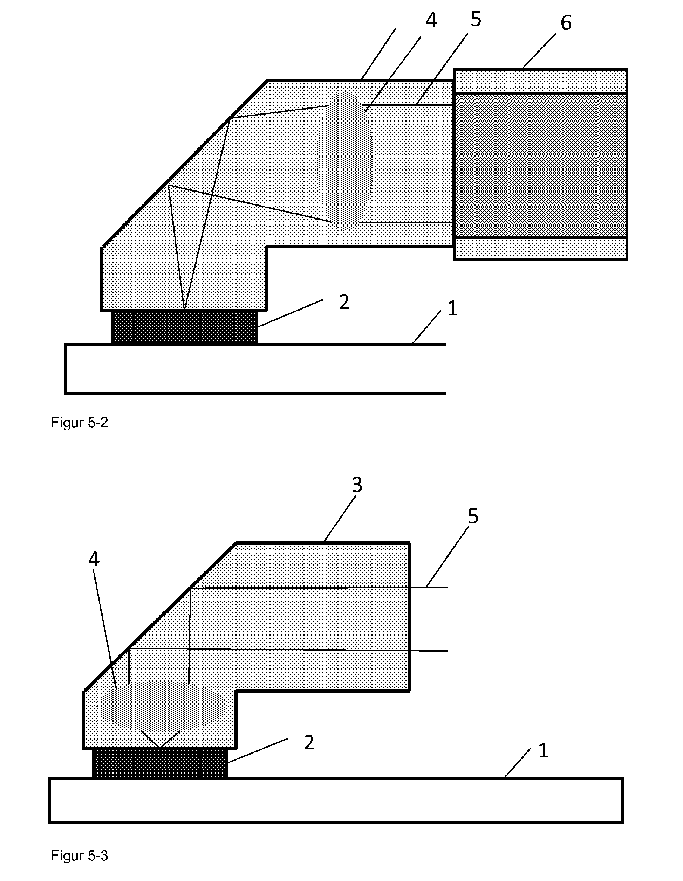

In der Variante gemäß **Figur 5-2** ist die Austrittsfläche des Umlenkelements 3 direkt mit einer Lichtleitfaser verbunden ("butt coupling"). Auch diese Lichtleitfaser kann eine Glasfaser, hier insbesondere eine Multimode-Faser, oder ein durch TPA/MPA strukturierter Wellenleiter sein.

Anhand der **Figur 5-3** lässt sich gut ablesen, dass die Strahlumlenkung ganz allgemein nicht notwendigerweise in der Reihenfolge "erst Reflexion, dann Strahlformung" ablaufen muss. In dieser Figur ist eine Abwandlung der Form E gezeigt, in der der Lichtstrahl zuerst die Linse und erst danach die Reflexionsfläche passiert.

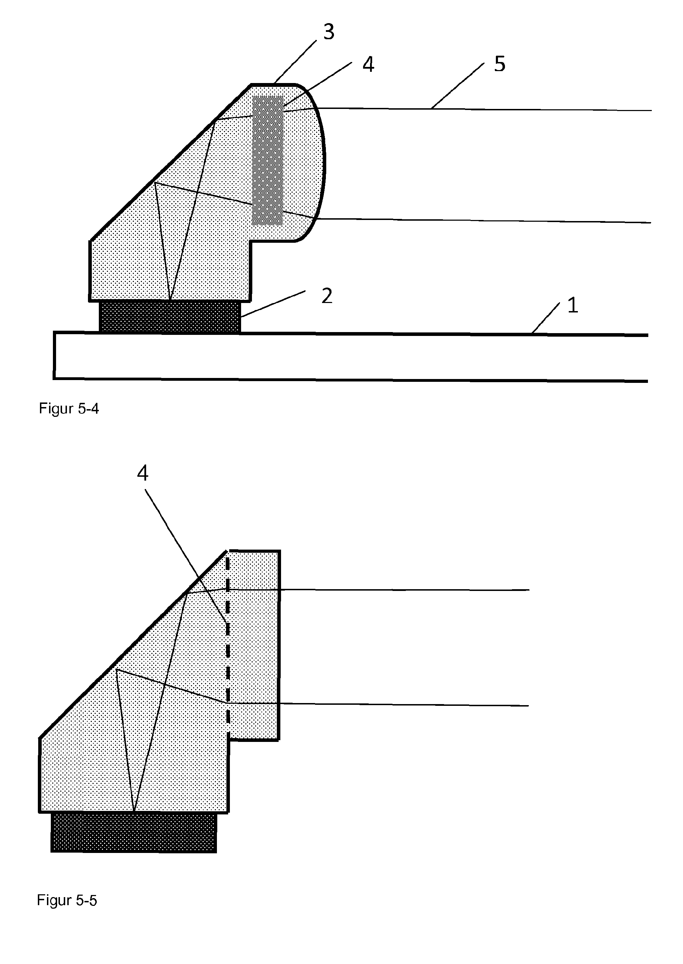

Mit der **Figur 5-4** soll verdeutlicht werden, dass nicht nur Linsen als integrales Strahl-Umform-Element in Frage kommen. Hier ist schematisch ein Element 4 in das erfindungsgemäße Umlenkelement integriert, das stellvertretend für ein beliebiges, eine Volumenstrukturierung bewirkendes Element stehen soll, beispielsweise eine "klassische" Linse, eine Abfolge von mehreren Linsen, ein diffraktives optisches Element, ein Flächenhologramm, ein Volumenhologramm oder ein Metamaterial. Es kann sich dabei auch um eine Einrichtung zur Strahlzusammenführung (Fan-in Element) oder eine Einrichtung zur Strahlauftrennung (Fan-out Element) handeln.

In der gezeigten Form tritt der Lichtstrahl über eine gekrümmte Fläche aus dem Strahlumlenkelement aus; je nach den Bedingungen, denen der Strahl bereits zuvor im Inneren des Umlenkelements unterworfen ist, kann diese Fläche aber auch eben gewählt werden.

Der Spezialfall eines integrierten diffraktiven optischen Elements 4 (DOE) in dieser Variante ist in **Figur 5-5** verdeutlicht.

Einen weiteren Spezialfall zeigt die Variante der **Figur 5-6****.** Hier ist das diffraktive optische Element (DOE) in die reflektierende Fläche des Strahlumlenkelements integriert. Hierdurch wird der auf die reflektierende Fläche auftreffende Strahl nicht nur reflektiert, sondern gleichzeitig wird dessen Phase und/oder dessen Amplitude moduliert, wodurch es zu Interferenz- und/oder Intensitätsmustern innerhalb der Strahlgeometrie kommt.

Bei dem DOE kann es sich in beiden Fällen beispielsweise um eine Phasenplatte in Form einer Fresnelschen Zonenplatte zur Fokussierung handeln.

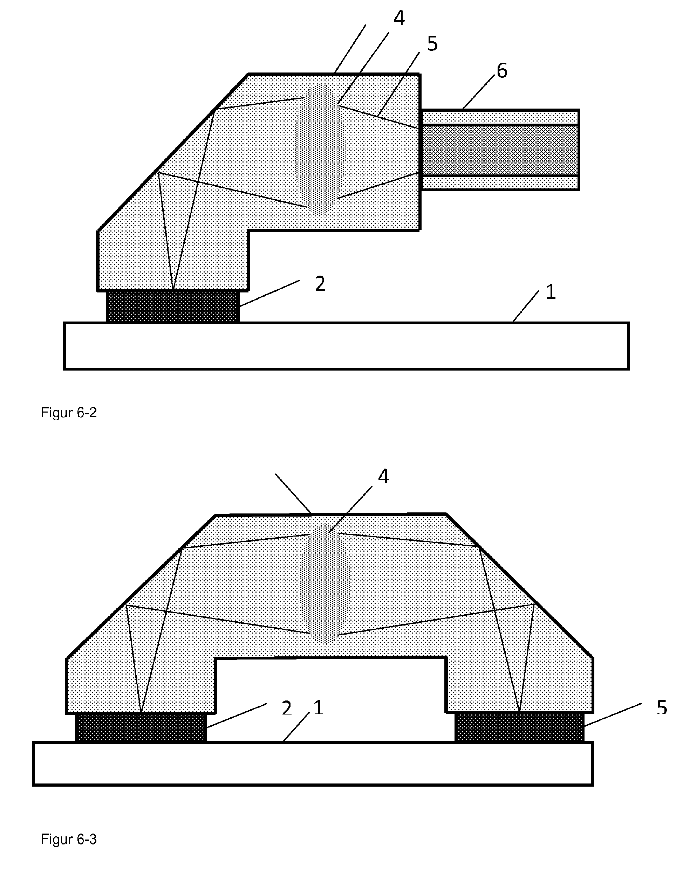

Die Grundform F, dargestellt in **Figur 6-1****,** zeigt eine Variante der Form E mit Linse, in der die Linse so geformt ist, dass kein Parallelstrahl, sondern ein konvergenter Lichtstrahl aus dem Umlenkelement austritt. Dieser kann auf ein beliebiges optisches Element oder Objekt gerichtet sein, beispielsweise den Eingang einer Lichtleitfaser (gezeigt in Figur 6-2) oder auf eine separate Linse, die Bestandteil des Lichtumlenkelements ist wie für die Formen C und D erläutert.

**Figur 6-3** zeigt auf Basis der Grundform F eine Variante, die im allgemeinen Teil der Beschreibung als "zusammengesetztes Element" bezeichnet wird, d.h. ein Strahlumlenkelement, das die notwendigen Funktionen und Geometrien des "einfachen Grundelements E" doppelt aufweist, und zwar in diesem Fall spiegelsymmetrisch (in diesem Fall fungieren die beiden Außenfläche der Linse jeweils als die Strahldivergenz und/oder die Strahlform änderndes Element, wobei die eine dem ersten Teil und die andere dem zweiten Teil des zusammengesetzten Elements zuzuordnen ist). Ein solches Element kann genutzt werden, um Strahlung von einem auf der Oberfläche 1 des Substrats angeordneten Strahlungsausgangselement 2 (einem Laser o.ä.) zu einem auf derselben Oberfläche angeordneten Strahlungseingangselement 5 (einem Detektor oder dergleichen) zu führen, wobei die Linse (oder alternativ eine Linsenabfolge oder dergleichen) dazu genutzt werden kann, um Eigenschaften wie die Strahlform, Ein- und Auskoppelrichtung und numerische Apertur auf dem Weg von der Lichtquelle zum Detektor zu verändern. Dieses Strahlumlenkelement kann natürlich in gleicher Weise Licht von einem Strahlungsausgangselement auf der Oberfläche eines ersten Substrats zu einem Strahlungseingangselement auf der Oberfläche eines zweiten Substrats transportieren.

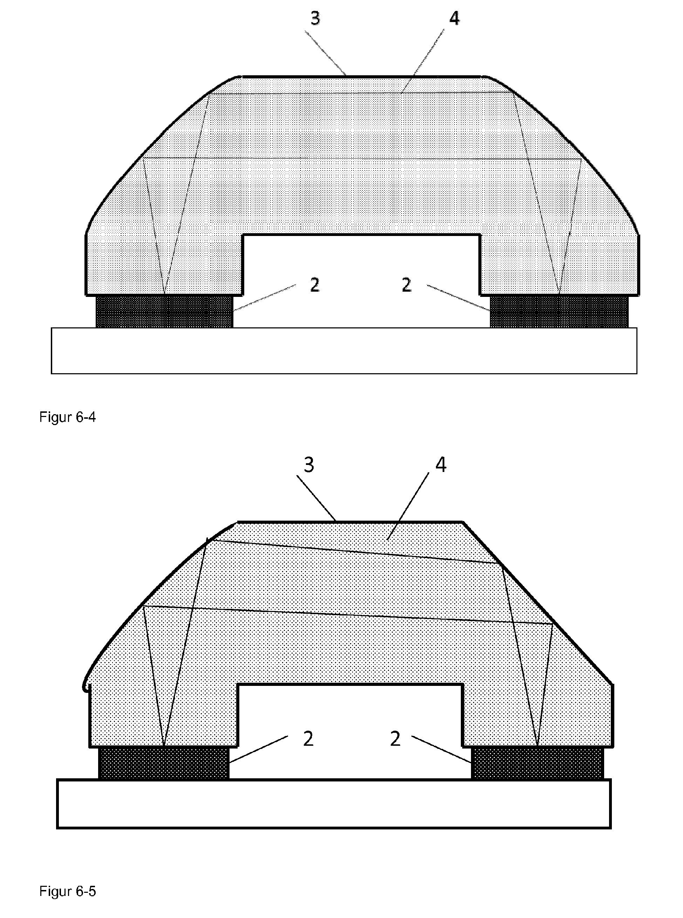

In einer spezifischen Variante dieser Ausführungsform kann die Reflexionsfläche des Elements gleichzeitig gekrümmt sein derart, dass der Lichtstrahl kollimiert und parallel zur gegenüberliegenden gekrümmten Reflexionsfläche geführt wird. Eine Linse wird in diesem Fall nicht benötigt. Diese Variante (gezeigt in Figur **6-4**) lässt sich als "zusammengesetztes Element" der aus dem Stand der Technik bekannten Grundform G beschreiben, wobei die erfinderische Weiterentwicklung zum zusammengesetzten Element den dieser Grundform anhaftenden technischen Nachteil der gekoppelten Funktionen Umlenkung und Fokussierung nicht aufweist, da der Lichtstrahl das Element auf seinem Weg vom Strahlungsausgangselement zum Strahlungseingangselement nicht verlässt und daher sowohl Sollhöhe als auch Solldurchmesser des Strahls im Rahmen der Geometrie des Umlenkelements beliebig gewählt werden können. Auch formal unterfällt diese Variante der Erfindung, weil das Umlenkelement eine erste die Strahlung beeinflussende Fläche, die eine Umlenkung mindestens eines Teils der einfallenden Strahlung bewirkt, und eine zweite die Strahlung beeinflussende Fläche aufweist, die bewirkt, dass sich die Strahldivergenz und/oder die Strahlform ändert. Diese Variante (also ein Umlenkelement mit nur zwei den Weg der durch das Element hindurchtretenden Strahlung beeinflussenden Flächen, bei denen es sich um zwei außenliegende, einander gegenüberliegende, gekrümmte Reflexionsflächen handelt), ist jedoch erfindungsgemäß weniger bevorzugt als alle anderen Varianten.

Die in Fig. 6-4 gezeigte Variante muss nicht notwendigerweise symmetrisch aufgebaut sein, was im Übrigen für alle "zusammengesetzten" Strahlumlenkelemente der Erfindung gilt. Trifft die Strahlung des Strahlungsausgangselements beispielsweise zuerst auf eine Reflexionsfläche, die derart gekrümmt ist, dass ein (z.B. konvergenter) Lichtstrahl entsteht, dessen Schwerpunkt einen Winkel zur Substratoberfläche aufweist, kann dieser Lichtstrahl auf der gegenüberliegenden Seite durch eine geeignet geneigte Spiegelfläche wieder eingefangen und ins Strahlungseingangselement geführt werden, siehe **Figur 6-5****.** In dieser Ausführung kann der Emitter z.B. eine andere Strahldivergenz haben, als der Detektor akzeptiert. Wenn beispielsweise der Emitter einen ±10° Kegel ausstrahlt, der Detektor aber nur senkrechtes Licht mit ±1 ° akzeptiert, muss das Strahlenbündel auf dem zweiten Spiegel sehr schmal sein, um alles Licht in den Detektor zu koppeln. Ein asymmetrischer Strahlengang erfordert asymmetrische Elemente. Analog kann die Strahlform angepasst werden. Diese Variante kann z.B. bei einer Strahlumlenkung eines Strahls aus einem kantenemittierenden Laser mit rechteckiger Austrittsfacette als Strahlungsaustrittselement zu einem Detektor mit runder Eintrittsfacette eingesetzt werden.

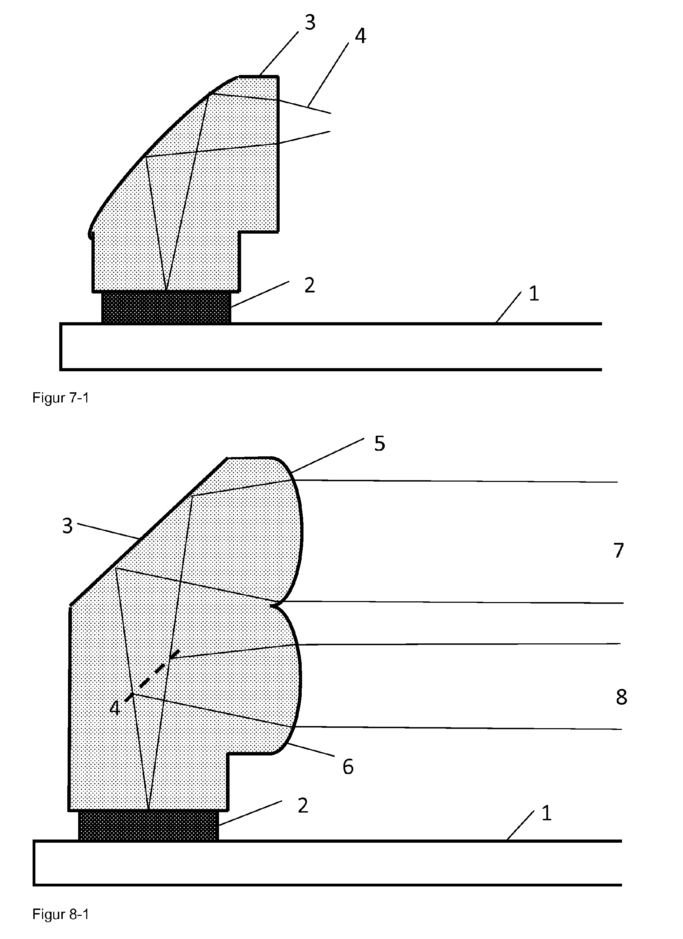

In **Figur 7-1** ist eine Ausgestaltung eines Strahlumlenkelements mit einer nicht gekrümmten Austrittsfläche gezeigt. Hier bewirkt die Brechzahldifferenz zwischen dem Material des Umlenkelements und dem der äußeren Umgebung in Kombination mit dem Winkel, mit dem der Strahl auf diese Fläche auftrifft, eine zusätzliche Umlenkung, nämlich eine stärkere Konvergenz des Strahlungsbündels im Vergleich zu dessen Form im Inneren des Umlenkelements.

In spezifischen Ausführungsformen der Erfindung enthält das Strahlumlenkelement zusätzliche optisch wirksame Elemente. Ein Beispiel ist ein sogenannter "Multiplexer", der die optischen Pfade des Lichtstrahls für verschiedene Wellenlängen auftrennt. Ein solches Element kann ein Gitter, ein DOE, ein Hologramm, ein photonischer Kristall oder ein dichroischer Spiegel sein. In manchen Fällen lässt sich dieser Multiplexer mittels TPA/MPA direkt in das Volumen des Strahlumlenkelements "schreiben". Ansonsten kann er als vorgefertigtes Element in das noch nicht endverfestigte Material des Strahlumlenkelements eingebettet werden, wie oben z.B. für die Linsen der Variante E, Figur 6-1, 6-3 beschrieben.

Eine mögliche Variante eines einen Multiplexer enthaltenden Umlenkelements ist in Figur **8-1** gezeigt. Ein Multiplexer 4 teilt den Strahl in zwei vertikale Komponenten 7, 8 mit unterschiedlichen Wellenlängen auf, die das Umlenkelement durch die linsenförmigen Flächen 5 und 7 verlassen. Diese Form setzt eine extrem hohe Positioniergenauigkeit voraus.

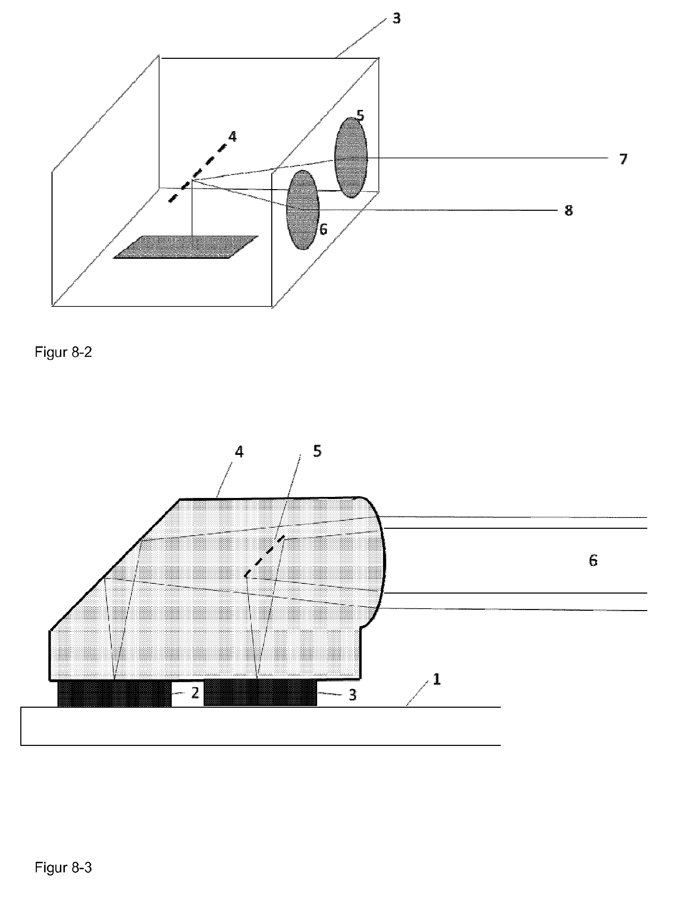

In Figur **8-2** ist eine andere Variante mit einem Multiplexer 4 gezeigt, der den Strahl in zwei horizontale Komponenten 7, 8 aufteilt, die durch entsprechende Linsen 5, 6 aus dem Umlenkelement austreten.

Mit derartigen Varianten lässt sich eine Vielzahl von möglichen Strahlformen realisieren. So lassen sich beispielsweise die Pfade von Licht zweier oder einer größeren Zahl unterschiedlicher Wellenlängen, die aus zwei oder mehreren unter einem einzigen Strahlumlenkelement liegenden Strahlungsausgangselementen in das Umlenkelement eintreten, über ein in das Volumen geschriebenes Element trennen. Damit lassen sich parallele, fokussierende oder divergierende Lichtstrahlen formen, die z.B. aus Licht unterschiedlicher Wellenlängen zusammengesetzt sind, wobei verschiedene Teile des Strahls, im Querschnitt gesehen, in unterschiedlicher Weise Licht der verschiedenen Wellenlängen enthalten. So kann, wie in Figur **8-3** schematisch dargestellt, über ein flächiges Gitter oder sonstiges Flächenelement 5 ein Strahlbündel geformt werden, dessen Kern einen gemeinsamen Lichtpfad für das aus den beiden Strahlungsausgangselementen 2 und 3 austretende Licht bildet, wobei die beiden Strahlungsausgangselemente Licht unterschiedlicher Wellenlängen emittieren. Dabei ist das Umlenkelement so geformt, dass das aus 2 austretende Licht der Wellenlänge 1 an einer Spiegelfläche derart gespiegelt wird, dass es nach Austritt durch die linsenförmige Grenzfläche des Umlenkelements einen breiteren Parallelstrahl formt als das aus 3 emittierte Licht der Wellenlänge 2, das am Element 5 gespiegelt wird. Dabei ist das Element 5 so gebildet, das das Licht der Wellenlänge 1 hindurchtreten kann.

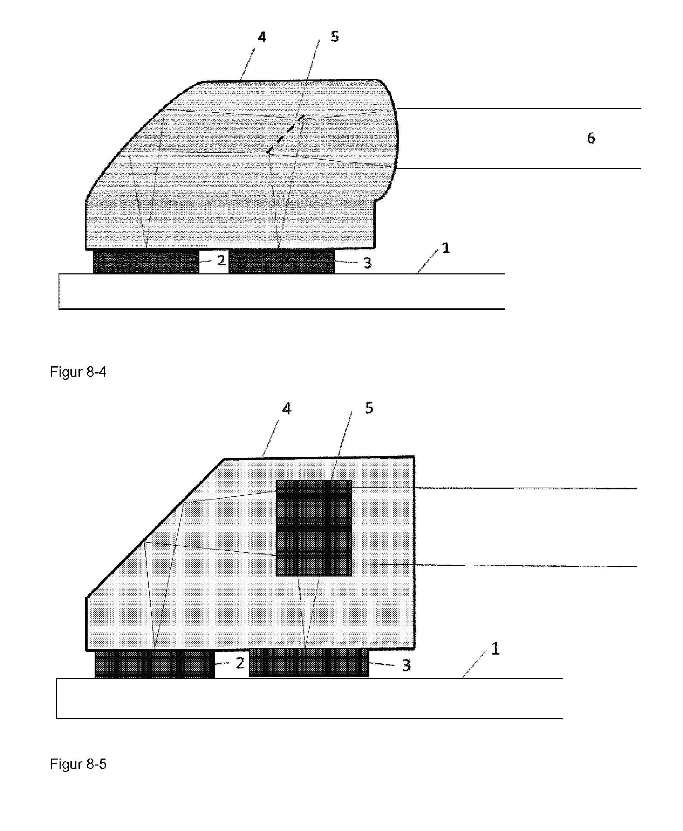

Hat das Element 5 eine wellenlängenabhängige Brechkraft (Dispersion), lässt sich diese Dispersion so wählen, dass beide Pfade in Ort, Richtung und Durchmesser gleich sind. Wie in **Figur 8-4** gezeigt, besteht der kollimierte Strahl 6 in diesem Fall an allen Orten seines Durchmessers aus derselben Mischung der beiden aus 2 und 3 emittierten Wellenlängen.

Anstelle eines flächigen Elements ist es auch möglich, ein komplexes Volumen-strukturiertes Element im Umlenkelement vorzusehen, z.B. einen photonischen Kristall, ein Hologramm oder ein Metamaterial. Das Strahlschema, das sich damit erzielen lässt, ist mit dem des Flächenelements vergleichbar, siehe **Figur 8-5****,** worin der Quader 5 das Volumenelement symbolisiert.

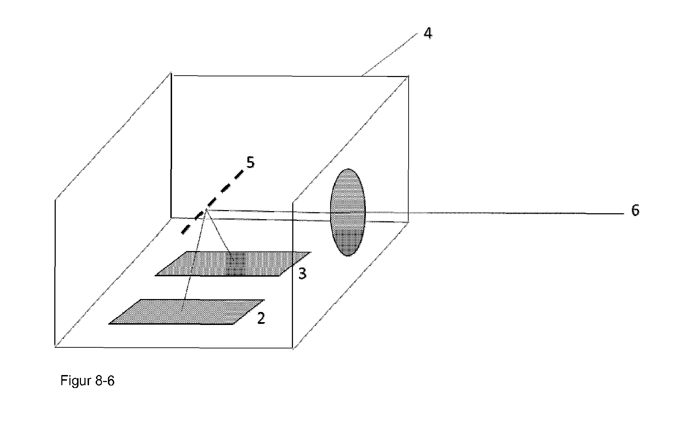

Natürlich müssen sich die beiden Strahlungsausgangselemente nicht hintereinander befinden, bezogen auf den Strahlungspfad, wie in den Beispielen der Figuren 8-4 und 8-5 gezeigt, sondern sie können auch nebeneinander angeordnet sein. Ein entsprechendes Beispiel zeigt **Figur 8-6****.**

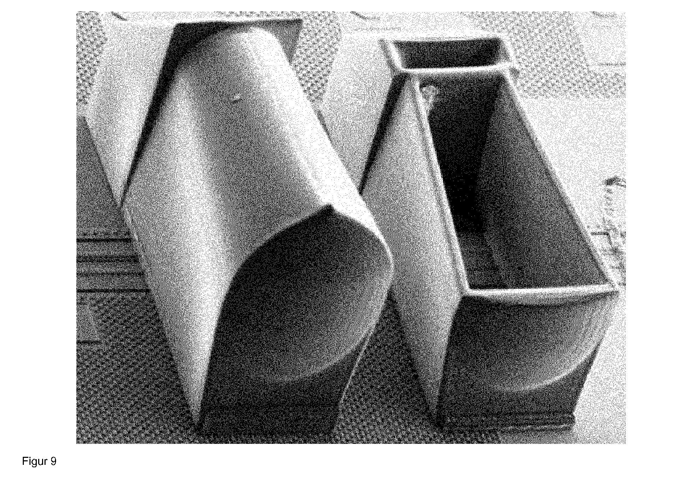

In **Figur 9** sind elektronenmikroskopische Aufnahmen von zwei Strahlumlenkelementen der Grundform A gezeigt. Das linke Umlenkelement ist korrekt gebildet, das rechte ist unvollständig (um einen Einblick ins Innere zu vermitteln, ist der oberste Bereich weggeschnitten, und der Rest des Elements ist hohl). Ein Strahlungsausgangselement befindet sind unter dem hinteren Teil der Elemente; der Lichtstrahl trifft auf seinem Weg nach oben die hinten links sichtbare schräge Fläche, an der er reflektiert wird. Er läuft von hinten nach schräg vorne durch den leicht konisch geformten Körper des Elements und tritt vorne an der gekrümmten Fläche aus.

## Patentansprüche

1. Strahlumlenkelement mit Abmessungen von unter 1 mm in allen drei Raumrichtungen, das zur Anordnung auf einem Strahlungsausgangs- und/oder -eingangselement vorgesehen ist und eine Eintrittsfläche für eintretende Strahlung sowie eine Austrittsfläche für diese Strahlung besitzt, wobei mindestens eine dieser Flächen eben ausgebildet ist, derart, dass sie auf einer Austritts- oder Eintrittsfläche eines Strahlungsausgangs- oder -eingangselements zu liegen kommen kann, wobei die Eintrittsfläche und die Austrittsfläche des Strahlumlenkelements winklig zueinander angeordnet sind, **dadurch gekennzeichnet, dass** das Strahlumlenkelement mindestens zwei den Weg der durch das Element hindurchtretenden Strahlung beeinflussende Flächen aufweist, deren eine eine Umlenkung mindestens eines Teils der einfallenden Strahlung bewirkt und deren andere bewirkt, dass sich die Strahldivergenz und/oder die Strahlform ändert.

2. Strahlumlenkelement nach Anspruch 1, worin diejenige Fläche des Strahlumlenkelements, die eine Änderung der Strahldivergenz und/oder der Strahlform bewirkt, eine gekrümmte Fläche oder eine ebene Fläche ist, die als Eintritts- oder Austrittsfläche für Strahlung dient.

3. Strahlumlenkelement nach Anspruch 2, worin diejenige Fläche des Strahlumlenkelements, die eine Änderung der Strahldivergenz und/oder der Strahlform bewirkt, eine Strahlungsaustrittsfläche ist und gegenüber der Fläche, über die der Strahl eintritt, einen Winkel von zwischen 70 und 110°, stärker bevorzugt zwischen 80 und 100° und besonders bevorzugt von etwa 90° aufweist, oder dass diejenige Fläche des Strahlumlenkelements, die eine Änderung der Strahldivergenz und/oder eine Strahlformänderung bewirkt, eine Strahlungseintrittsfläche ist und gegenüber der Fläche, über die der Strahl austritt, einen Winkel von zwischen 70 und 110°, stärker bevorzugt zwischen 80 und 100° und besonders bevorzugt von etwa 90° aufweist.

4. Strahlumlenkelement nach Anspruch 1, worin diejenige Fläche die eine Änderung der Strahldivergenz und/oder der Strahlform bewirkt, ein diffraktives optisches Element, eine Linse, eine Linsenkombination, ein Flächenhologramm, ein Volumenhologramm, ein Metamaterial oder eine Kombination aus mehreren der genannten Elemente im Inneren des Strahlumlenkelements ist, wobei die Eintrittsfläche für eintretende Strahlung und die Austrittsfläche für diese Strahlung vorzugsweise einen Winkel von zwischen 70 und 110°, stärker bevorzugt zwischen 80 und 100° und besonders bevorzugt von etwa 90° zueinander besitzen.

5. Strahlumlenkelement nach Anspruch 1, **dadurch gekennzeichnet, dass** es zwei- oder mehrteilig ausgebildet ist, wobei eine Fläche eines ersten Teils des Strahlumlenkelements eben ausgebildet ist, derart, dass sie auf einer Austritts- oder Eintrittsfläche eines Strahlungsausgangs- oder -eingangselements zu liegen kommen kann, und wobei der zweite Teil des Strahlumlenkelements zur Anordnung auf einem Substrat ausgebildet ist, wobei der erste Teil des Strahlumlenkelements eine Fläche aufweist, die eine Umlenkung mindestens eines Teils der einfallenden Strahlung bewirkt, und der zweite Teil des Strahlumlenkelements eine Fläche aufweist, die bewirkt, dass sich die Strahldivergenz und/oder Strahlform ändert, oder *vice versa.*

6. Strahlumlenkelement nach Anspruch 1, das zur Anordnung auf einem Strahlungsausgangs- und einem Strahlungseingangselement vorgesehen ist und eine Eintrittsfläche für eintretende Strahlung sowie eine Austrittsfläche für diese Strahlung besitzt, die parallel zueinander und vorzugsweise in derselben Ebene liegen, umfassend mindestens zwei Flächen, die eine Umlenkung mindestens eines Teils der einfallenden Strahlung bewirken, und mindestens zwei Flächen, die bewirken, dass sich die Strahldivergenz und/oder Strahlform der einfallenden Strahlung ändert, wobei diese Flächen so zueinander angeordnet sind, dass der Strahl vom Strahlungsausgangselement durch das Strahlumlenkelement in das Strahlungseingangselement geführt werden kann.

7. Strahlumlenkelement nach Anspruch 6, worin jede der mindestens zwei Flächen, die bewirken, dass sich die Strahldivergenz und/oder Strahlform ändert, Bestandteil einer Linse, einer Abfolge von zwei oder mehr Linsen, einer Fresnel'schen Zonenplatte, eines Gitters, eines diffraktiven optischen Elements, eines Flächenhologramms, eines Volumenhologramms oder eines Metamaterials sind.

8. Strahlumlenkelement nach Anspruch 1, das in seinem Inneren mindestens einen Strahlteiler aufweist, der eine Aufteilung der aus dem Strahlungsausgangselement austretenden Lichtstrahlung in zwei oder mehr parallele oder in verschiedene Raumrichtungen weisende Teilstrahlen bewirkt, oder der eine Einrichtung zur Strahlzusammenführung aufweist, wobei die Lichtstrahlung im Falle der Teilung räumlich und/oder nach Wellenlängen aufgetrennt beziehungsweise zusammengeführt wird.

9. Optisches Bauelement, umfassend
ein Substrat mit einer Substratoberfläche (1),
ein auf der Substratoberfläche befindliches Strahlungsausgangselement (2) und/oder ein auf der Substratoberfläche befindliches Strahlungseingangselement (2) und
ein Strahlumlenkelement (3) nach einem der voranstehenden Ansprüche, das zumindest teilweise unmittelbar auf einem Strahlungsausgangs- oder -eingangselement (2) auf der Substratoberfläche (1) angeordnet und so gestaltet ist, dass es elektromagnetische Strahlung, die im Wesentlichen vertikal zur Substratoberfläche (1) aus dem Strahlungsausgangselement (2) austritt, umlenkt und dabei einen Strahl bildet, der gegenüber dem Austrittswinkel, den der das Strahlungsausgangselement verlassende Strahl mit der Substratoberfläche bildet, einen kleineren oder sogar negativen Winkel besitzt oder parallel zur Substratoberfläche ausgerichtet ist, oder dass es elektromagnetische Strahlung, die mit einem bestimmten Winkel zur Substratoberfläche in das Strahlumlenkelement (3) eintritt, fokussiert und in das Strahlungseingangselement lenkt.

10. Optisches Bauelement nach Anspruch 9, worin das Strahlumlenkelement zwei- oder mehrteilig ausgebildet ist, wobei ein erster Teil zumindest teilweise unmittelbar auf einem Strahlungsausgangs- oder -eingangselement auf der Substratoberfläche (1) angeordnet ist und ein zweiter Teil an einer Position auf der Oberfläche des Substrats angeordnet ist derart, dass er sich zwingend unmittelbar im Strahlengang der aus dem ersten Teil austretenden oder in diesen Teil eintretenden Strahlung oder zumindest einem Teil davon befindet, wobei der erste Teil des Strahlumlenkelements eine Fläche aufweist, die eine Umlenkung mindestens eines Teils der einfallenden Strahlung bewirkt, und der zweite Teil des Strahlumlenkelements eine Fläche aufweist, die bewirkt, dass sich die Strahldivergenz und/oder die Strahlform des auftreffenden Strahls ändert, oder *vice versa.*

11. Optisches Bauelement nach Anspruch 9, umfassend ein auf der Substratoberfläche angeordnetes Strahlungsausgangselement (2), wobei das Strahlumlenkelement teilweise unmittelbar auf dem Strahlungsausgangselement angeordnet ist, **dadurch gekennzeichnet, dass** das Strahlumlenkelement weiterhin teilweise unmittelbar auf einem Strahlungseingangselement (5) angeordnet ist, das Teil eines zweiten optischen Bauelements ist, und wobei das Strahlumlenkelement (3) mindestens zwei Flächen, die eine Umlenkung mindestens eines Teils der einfallenden Strahlung bewirken, und mindestens zwei Flächen aufweist, die bewirken, dass sich die Strahldivergenz und/oder Strahlform ändert, wobei diese Flächen so zueinander angeordnet sind, dass der Strahl vom Strahlungsausgangselement des optischen Bauelements durch das Strahlumlenkelement in das Strahlungseingangselement des zweiten optischen Bauelements geführt wird.

12. Optisches Bauelement nach einem der Ansprüche 9 bis 11, weiterhin umfassend einen Wellenleiter.

13. Optisches Bauelement nach Anspruch 12, worin der Wellenleiter in unmittelbarer Nachbarschaft zu einer ebenen Strahlungseingangs- oder -ausgangsfläche des Strahlumlenkelements angeordnet ist.

14. Optisches Bauelement nach Anspruch 12, worin der Wellenleiter zu einer Strahlungseingangs- oder -ausgangsfläche des Strahlumlenkelements beabstandet angeordnet ist.

15. Optisches Bauelement nach Anspruch 14, worin der Raum zwischen der ebenen Strahlungseingangs- oder -ausgangsfläche des Strahlumlenkelements und dem Wellenleiter mit Gas, Vakuum, einer Flüssigkeit oder einem Festkörper ausgefüllt ist, wobei der Festkörper einen anderen Brechungsindex aufweist als das Material, das die Strahlungseingangs- oder -ausgangsfläche des Strahlumlenkelements bildet, und als das Material, aus dem der Wellenleiter gebildet ist.
